(19) Europäisches Patentamt / European Patent Office / Office européen des brevets

(11) **EP 4 730 564 A1**

(12) **EUROPEAN PATENT APPLICATION**
published in accordance with Art. 153(4) EPC

(43) Date of publication:
**22.04.2026 Bulletin 2026/17**

(21) Application number: **24822681.3**

(22) Date of filing: **11.06.2024**

(51) International Patent Classification (IPC):
*H01Q 15/08* (2006.01)

(52) Cooperative Patent Classification (CPC):
Y02P 10/25

(86) International application number:
**PCT/CN2024/098429**

(87) International publication number:
**WO 2024/255731 (19.12.2024 Gazette 2024/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 15.06.2023  CN 202310709691
27.05.2024  CN 202410667877

(71) Applicants:
• **South China University of Technology**
**Guangzhou, Guangdong 510000 (CN)**
• **Shenzhen Maxwellhertz Technology Co., Ltd.**
**Shenzhen, Guangdong 518000 (CN)**

(72) Inventors:
• **XUE, Quan**
**Shenzhen, Guangdong 518000 (CN)**
• **DONG, Zheng**
**Shenzhen, Guangdong 518000 (CN)**
• **ZHOU, Xianting**
**Shenzhen, Guangdong 518000 (CN)**

(74) Representative: **Petraz, Gilberto Luigi et al**
**GLP S.r.l.**
**Viale Europa Unita, 171**
**33100 Udine (IT)**

(54) **ARTIFICIAL DIELECTRIC MATERIAL, LENS UNIT AND MANUFACTURING METHOD THEREFOR, AND LENS ANTENNA**

(57)    The present disclosure provides an artificial dielectric material, a lens unit, a fabrication method for the lens unit, and a lens antenna. The artificial dielectric material includes a substrate and a conductive material. The substrate is configured as a porous structure and defines multiple microporous chambers. The conductive material is disposed on all side walls of the microporous chambers, where a shape of the microporous chambers and/or at least one of a shape, size, density, or extension direction of the conductive material are adjusted to obtain desired effective dielectric constants. The artificial dielectric material provided in the present disclosure has a stable structure, does not deform after long-term use, is acid-resistant, waterproof, and flame-retardant, and has a density of less than 30kg/m$^3$. The conductive material will not fall off, and a relative position between the conductive materials is fixed, such that the conductive materials will not contact with one another, and an intermodulation indicator of the base station antenna will not be affected. Therefore, the artificial dielectric material and the fabrication method therefor provided in the present disclosure provide a higher degree-of-freedom for the design of the lens unit and the lens antenna.

FIG. 5

EP 4 730 564 A1

**Description**

CROSS-REFERENCE TO RELATED APPLICATION(S)

This application claims priority to Chinese Patent Application No. 202310709691.1, filed Month June 15, 2023 and entitled "ARTIFICIAL DIELECTRIC MATERIAL, LENS UNIT, FABRICATION METHOD FOR THE LENS UNIT, AND LENS ANTENNA", and Chinese Patent Application No. 202410667877.X, filed Month May 27, 2024 and entitled "ARTIFICIAL DIELECTRIC MATERIAL, LENS UNIT, FABRICATION METHOD FOR THE LENS UNIT, AND LENS ANTENNA", the entire disclosure of which is hereby incorporated by reference.

TECHNICAL FIELD

This disclosure relates to the field of antenna technology, in particular to an artificial dielectric material, a lens unit, a fabrication method for the lens unit, and a lens antenna.

BACKGROUND

Signal coverage for long and narrow areas such as high-speed railways, highways, rivers, or tunnels has always been a challenging issue. This is because these scenarios are very long in a longitudinal direction but have a low requirement in a horizontal direction. A traditional base station antenna typically has an azimuth-plane beam width and an elevation-plane beam width of around 65° and 10°, respectively. Such radiation pattern does not match well with the long and narrow terrain when providing signal coverage. Therefore, even with a high-gain linear array base station antenna, it is difficult to achieve satisfactory coverage, and the capacity cannot be guaranteed.

A lens antenna can achieve secondary beam convergence of a feed radiation pattern by changing a path difference of electromagnetic waves in space, thereby achieving high gain or other performance improvements. The beam convergence effect can be effective for both the elevation plane beam and the azimuth plane beam, effectively addressing the limitations of a linear array antenna radiation pattern. The antenna is also suitable for signal coverage in scenarios such as large stadiums, densely populated residential areas, maritime regions, etc.

An artificial dielectric material generally has a high density. An insulating material must be disposed on a conductive material or between conductive materials; otherwise, contact between metal conductive micro-units may occur, leading to deterioration of the intermodulation and increasing manufacturing cost and complexity.

SUMMARY

The present disclosure provides an artificial dielectric material, a lens unit, a fabrication method for the lens unit, and a lens antenna.

In a first aspect, the present disclosure provides an artificial dielectric material. The artificial dielectric material includes a substrate and a conductive material. The substrate is configured as a porous structure and defines multiple microporous chambers. The conductive material is disposed on all side walls of the microporous chambers, where a shape of the microporous chambers and/or at least one of a shape, a size, or density of the conductive material are adjusted to obtain desired effective dielectric constants.

In a second aspect, the present disclosure provides a lens unit. The lens unit includes the artificial dielectric material.

In a third aspect, the present disclosure provides a fabrication method for the lens unit. The method includes the following operations. The substrate is provided, and the substrate is cut to an appropriate size. The conductive material is arranged on the substrate, where a molding shape, size, and distribution density of the conductive material are adjusted according to a lens design requirement during the arrangement, to achieve desired effective dielectric constants. The substrate is formed into a porous structure by means of a honeycomb preparation process, where the conductive material is arranged on all side walls of the microporous chambers. The substrate is processed into the lens unit.

In a fourth aspect, the present disclosure provides a lens antenna. The lens antenna includes the lens unit and a feed unit. The feed unit is fixed in spatial position relative to the lens unit.

In a fifth aspect, the present disclosure provides a lens antenna. The lens antenna includes a lens unit and at least one feed unit. The lens unit includes a substrate and multiple conductive materials, where the substrate is of a porous structure, the substrate defines multiple microporous chambers, and the multiple conductive materials are disposed on all side walls of the microporous chambers. The at least one feed unit is disposed facing towards or close to the lens unit, where a radiation surface of the at least one feed unit is disposed facing towards at least part of the multiple conductive materials, and an angle between a polarization direction of the at least one feed unit and an extension direction of a conductive structure is less than or equal to a preset angle.

BRIEF DESCRIPTION OF THE DRAWINGS

The present disclosure is further illustrated below with reference to accompanying drawings and embodiments.

FIG. 1 is a top view of a spherical lens unit along an axial direction of a honeycomb structure provided in embodiments of the present disclosure.

FIG. 2 is a detailed view of metal strips in a honeycomb structure provided in embodiments of the present disclosure.

FIG. 3 is a side view of the honeycomb microstructure in FIG. 2.

FIG. 4 is a schematic diagram illustrating that the long sides of the metal patterns are parallel to the honeycomb axial direction, and the metal patterns are uniformly arranged along the honeycomb axial direction, provided in embodiments of the present disclosure.

FIG. 5 is a schematic diagram illustrating a dual-polarized feed dipole provided in embodiments of the present disclosure, where one polarization is along the honeycomb axial direction, and the other polarization is perpendicular to the honeycomb axial direction.

FIG. 6 is a schematic structural diagram illustrating that a lens unit is of a rotatable structure and a feed unit has a relatively fixed position, provided in embodiments of the present disclosure.

FIG. 7a is a schematic structural diagram illustrating that a feed unit is of a rotatable structure and a lens unit has a relatively fixed position, provided in embodiments of the present disclosure.

FIG. 7b is a schematic structural diagram illustrating that a feed unit is of a rotatable structure and a lens unit is of a rotatable structure, provided in embodiments of the present disclosure.

FIG. 8 is a partial schematic structural diagram illustrating that a feed unit is a single-polarized antenna and an extension direction of a conductive material is parallel to the axis of the microporous chamber, provided in embodiments of the present disclosure.

FIG. 9a is a partial schematic structural diagram illustrating that the angle between the extension direction of the conductive material and the polarization direction of a dipole of the feed unit in the lens antenna provided in FIG. 8 is adjusted to a second angle range.

FIG. 9b is another partial structural schematic diagram illustrating that the angle between the extension direction of the conductive material and the polarization direction of a dipole of the feed unit in the lens antenna provided in FIG. 8 is adjusted to a second angle range.

FIG. 10a is a partial structural schematic diagram illustrating that the angle between the extension direction of the conductive material and the polarization direction of a dipole of the feed unit in the lens antenna provided in FIG. 8 is adjusted to a third angle range.

FIG. 10b is another partial structural schematic diagram illustrating that the angle between the extension direction of the conductive material and the polarization direction of a dipole of the feed unit in the lens antenna provided in FIG. 8 is adjusted to a third angle range.

FIG. 11 is a schematic structural diagram illustrating that a feed unit is able to rotate around a lens unit in the equatorial plane of the lens unit, provided in embodiments of the present disclosure.

FIG. 12a is a schematic structural diagram illustrating that a feed unit moves towards different side walls of a microporous chamber, provided in embodiments of the present disclosure.

FIG. 12b is a schematic structural diagram illustrating that a feed unit moves towards different side walls of a microporous chamber, and the angle between polarization directions of a dipole of the feed unit can be adjusted to a third angle range or a first angle range, provided in embodiments of the present disclosure.

FIG. 13a is a schematic diagram illustrating a beam when a second feed unit operates and both a first feed unit and a third feed unit do not operate, provided in embodiments of the present disclosure.

FIG. 13b is a schematic diagram illustrating beams when a first feed unit, a second feed unit, and a third feed unit all operate, provided in embodiments of the present disclosure.

FIG. 14a is a partial structural schematic diagram illustrating that a conductive material is disposed along an axis of a microporous chamber and a feed unit is a ±45° dual-polarized antenna, provided in embodiments of the present disclosure.

FIG. 14b is a partial structural schematic diagram illustrating that a conductive material is disposed along an axis of a microporous chamber and a feed unit is a dual-polarized antenna of 0° and 90°, provided in embodiments of the present disclosure.

FIG. 15 is a comparison diagram illustrating simulated radiation patterns for the polarization along the honeycomb axis, with and without the additional lens, provided in embodiments of the present disclosure.

FIG. 16 is a comparison diagram illustrating simulated radiation patterns for the polarization perpendicular to the honeycomb axis, with and without the additional lens, provided in embodiments of the present disclosure.

FIG. 17 is a schematic diagram illustrating a dual-polarized feed dipole with two polarizations oriented at ±45° angles relative to the honeycomb axis, provided in embodiments of the present disclosure.

FIG. 18 is a comparison diagram illustrating simulated radiation patterns for the $\pm 45°$ polarization (relative to the honeycomb axis) with and without the additional lens, provided in embodiments of the present disclosure.

FIG. 19a is a schematic diagram illustrating that the long sides of the metal strips are perpendicular to the honeycomb axial direction, and the metal strips are uniformly arranged along the honeycomb axial direction, provided in embodiments of the present disclosure.

FIG. 19b is a partial schematic structural diagram illustrating the conductive material provided in FIG. 19a and a feed unit which is a single-polarized antenna.

FIG. 19c is a partial schematic structural diagram illustrating the conductive material provided in FIG. 19a and a feed unit which is a $\pm 45°$ dual-polarized antenna.

FIG. 19d is a partial schematic structural diagram illustrating the conductive material provided in FIG. 19a and a feed unit which is a dual-polarized antenna of 0° and 90°.

FIG. 20a is a schematic diagram illustrating that metal strips which have long sides perpendicularly with the honeycomb axial direction are staggered with metal strips which have long sides parallel to the honeycomb axial direction and all metal strips are uniformly arranged along the honeycomb axial direction, provided in embodiments of the present disclosure.

FIG. 20b is a partial schematic structural diagram illustrating the conductive material provided in FIG. 20a and a feed unit which is a single-polarized antenna.

FIG. 20c is a partial schematic structural diagram illustrating the conductive material provided in FIG. 20a and a feed unit which is a $\pm 45°$ dual-polarized antenna.

FIG. 20d is a partial schematic structural diagram illustrating the conductive material provided in FIG. 20a and a feed unit which is a dual-polarized antenna of 0° and 90°.

FIG. 21a is a schematic diagram illustrating that the long sides of the metal strips are at an oblique angle of +45° relative to the honeycomb axial direction, and the metal strips are uniformly arranged along the honeycomb axial direction, provided in embodiments of the present disclosure.

FIG. 21b is a partial schematic structural diagram illustrating the conductive material provided in FIG. 21a and a feed unit which is a single-polarized antenna.

FIG. 21c is a partial schematic structural diagram illustrating the conductive material provided in FIG. 21a and a feed unit which is a $\pm 45°$ dual-polarized antenna.

FIG. 21d is a partial schematic structural diagram illustrating the conductive material provided in FIG. 21a and a feed unit which is a dual-polarized antenna of 0° and 90°.

FIG. 22a is a schematic diagram illustrating that the long sides of the metal strips are at an oblique angle of -45° relative to the honeycomb axial direction, and the metal strips are uniformly arranged along the honeycomb axial direction, provided in embodiments of the present disclosure.

FIG. 22b is a partial schematic structural diagram illustrating the conductive material provided in FIG. 22a and a feed unit which is a single-polarized antenna.

FIG. 22c is a partial schematic structural diagram illustrating the conductive material provided in FIG. 22a and a feed unit which is a $\pm 45°$ dual-polarized antenna.

FIG. 22d is a partial schematic structural diagram illustrating the conductive material provided in FIG. 22a and a feed unit which is a dual-polarized antenna of 0° and 90°.

FIG. 23a is a schematic diagram illustrating that metal strips which have long sides at an angle of +45° relative to the honeycomb axial direction are staggered with metal strips which have long sides at an angle of -45° with the honeycomb axial direction and all metal strips are uniformly arranged along the honeycomb axial direction, provided in embodiments of the present disclosure.

FIG. 23b is a partial schematic structural diagram illustrating the conductive material provided in FIG. 23a and a feed unit which is a single-polarized antenna.

FIG. 23c is a partial schematic structural diagram illustrating the conductive material provided in FIG. 23a and a feed unit which is a $\pm 45°$ dual-polarized antenna.

FIG. 23d is a partial schematic structural diagram illustrating the conductive material provided in FIG. 23a and a feed unit which is a dual-polarized antenna of 0° and 90°.

FIG. 24a is a schematic diagram illustrating that the long sides of the metal strips are at any angle with the honeycomb axial direction, and the metal strips are randomly arranged at any intervals along the honeycomb axial direction, provided in embodiments of the present disclosure.

FIG. 24b is a partial schematic structural diagram illustrating the conductive material provided in FIG. 23a and a feed unit which is a $\pm 45°$ dual-polarized antenna.

FIG. 24c is a partial schematic structural diagram illustrating that a first type of conductive materials with different extension directions is disposed on different side walls of a microporous chamber and a feed unit is a $\pm 45°$ dual-polarized antenna, provided in embodiments of the present disclosure.

FIG. 24d is a partial schematic structural diagram illustrating that conductive materials with different extension directions are disposed on different side walls of a microporous chamber and a feed unit is a dual-polarized antenna of 0° and 90°, provided in embodiments of the present disclosure.

FIG. 24e is a partial schematic structural diagram illustrating that a second type of conductive materials with different extension directions is disposed on different side walls of a microporous chamber and a feed unit is a ±45° dual-polarized antenna, provided in embodiments of the present disclosure.

FIG. 25a illustrates metal patterns of different shapes provided in embodiments of the present disclosure.

FIG. 25b is a partial schematic structural diagram illustrating the conductive material provided in FIG. 25a and a feed unit which is a ±45° dual-polarized antenna.

FIG. 26 is a comparison diagram of measured elevation-plane radiation patterns of two polarizations, parallel to metal strips and perpendicular to the metal strips, of an orthogonal dual-polarized feed dipole loading a lens with a diameter of 30 cm in an operating range of 1.7 GHz to 2.7 GHz when the metal strips are distributed as illustrated in FIG. 4, provided in embodiments of the present disclosure.

FIG. 27 is a comparison diagram of measured azimuth-plane radiation patterns of two polarizations, parallel to metal strips and perpendicular to the metal strips, of an orthogonal dual-polarized feed dipole loading a lens with a diameter of 30 cm in an operating range of 1.7 GHz to 2.7 GHz when the metal strips are distributed as illustrated in FIG. 4, provided in embodiments of the present disclosure.

Reference signs: lens antenna 1000, lens unit 100, microporous chamber 110, conductive material 200, feed unit 300, substrate 10, first rotatable drive structure 50, first drive motor 40, first curved track 31, third drive motor 32, third drive structure 33, first feed unit 310, second feed unit 320, third feed unit 330, second rotatable drive structure 51, second drive motor 41.

DETAILED DESCRIPTION

Embodiments of the present disclosure will be described in detail below with reference to examples thereof as illustrated in accompanying drawings, throughout which same or similar elements, or elements having same or similar functions, are denoted by same or similar reference numerals. Embodiments described below with reference to the accompanying drawings are illustrative only, and are intended to explain, rather than limiting, the present disclosure.

In the description of the present disclosure, the orientations or positional relationships indicated by the terms "up", "down", "front", "rear", "left", "right", etc., are based on the orientations or positional relationships illustrated in the accompanying drawings and are merely for ease in describing the present disclosure and simplifying this description, but not to indicate or imply that an indicated device or element must have a particular orientation and be constructed and operated in a particular orientation, and thus cannot be construed as limitations on the present disclosure.

In the description of the present disclosure, the term "several" means one or more, the term "a plurality of" or "multiple" means two or more, the terms "greater than", "less than", "exceed", etc. are interpreted as excluding this number, and the terms "above", "below", "within", etc. are interpreted as including this number. The terms "first" and "second", if stated, are only used to distinguish technical features, and cannot be understood as indicating or implying relative importance or implicitly indicating the number of the technical features indicated or implicitly indicating the precedence relationship of the technical features indicated.

In the description of the present disclosure, unless otherwise specified, the words "disposal", "mount", "connect", etc., can be understood in a broad sense, and specific meanings of these words in the present disclosure may be reasonably determined by those skilled in the art in combination with the specific contents of the technical solutions.

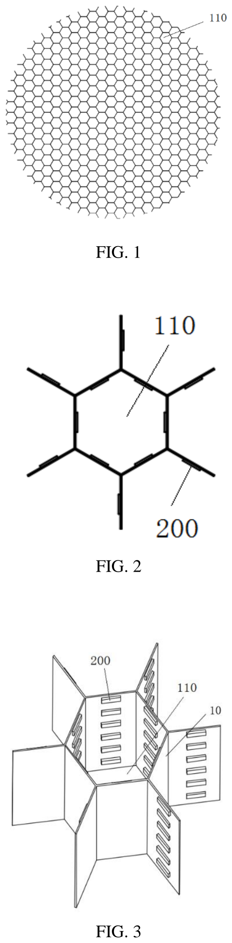

Reference can be made to FIG. 1 to FIG. 6, the present disclosure provides a lens antenna 1000, and the lens antenna 1000 includes a lens unit 100 and a feed unit 300. Optionally, the lens unit 100 can increase the gain of a beam radiated by the feed unit 300. Optionally, the lens unit 100 can reduce the azimuth-plane beam width and the elevation-plane beam width of the beam radiated by the feed unit 300, thereby increasing the gain of the beam radiated by the feed unit 300.

The lens unit 100 is designed to have an appropriate effective dielectric constant, such that beams can be converged after electromagnetic wave signals emitted by the feed unit 300 pass through the lens unit 100, that is, forming a parallel or nearly parallel beam, thereby improving the beam gain.

The present disclosure provides an artificial dielectric material with an appropriate effective dielectric constant and improved beam gain.

Reference can be made to FIG. 1 to FIG. 27, the artificial dielectric material is provided in the first aspect of embodiments of the present disclosure, and the artificial dielectric material is applicable to the lens unit 100.

Reference can be made to FIG. 2 and FIG. 3, and the artificial dielectric material includes a substrate 10 and a conductive material 200. It can be understood that the conductive material 200 is a metal pattern.

Reference can be made to FIG. 1 to FIG. 3. The substrate 10 is configured as a porous structure and defines multiple microporous chambers 110. The conductive material 200 is disposed on all side walls of the multiple microporous chambers 110, where the shape of each of the multiple microporous chambers 110 and/or at least one of the shape, size, density, or extension direction of the conductive material 200 are adjusted to obtain different effective dielectric constants.

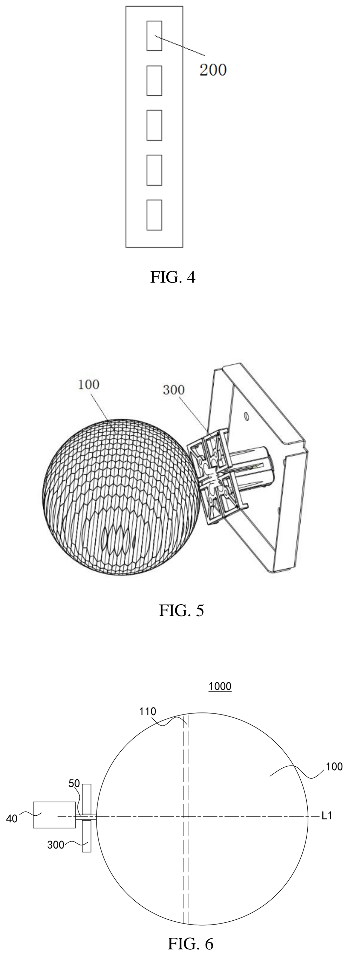

Reference can be made to FIG. 5. At least one feed unit 300 is disposed facing towards or close to the lens unit 100. A radiation surface of the feed unit 300 is disposed facing towards at least part of the conductive materials 200. An angle between the polarization direction of the feed unit 300 and the extension direction of the conductive material 200 is less than or equal to a preset angle. Optionally, the preset angle is 90°. The angle between the polarization direction of the feed unit 300 and the extension direction of the conductive material 200 is less than or equal to 90°. For the lens antenna 1000, a beam of the lens antenna 1000 is related to the angle between the polarization direction of the feed unit 300 and the extension direction of the conductive material 200. By designing the angle between the polarization direction of the feed unit 300 and the extension direction of the conductive material 200 to be less than or equal to 90°, the beam gain of the lens antenna 1000 can be changed.

The extension direction of the conductive material 200 refers to an effective induction length direction of a space electromagnetic field of the conductive material. When the feed unit 300 has two polarization directions of $\pm 45°$, the effective induction length direction of the space electromagnetic field of the conductive material is equivalent to both of the two polarization directions of $\pm 45°$. In other words, when the conductive material is in a square shape, the extension direction of the conductive material can be the side length direction or the diagonal direction. When the conductive material is in a rectangular shape, the extension direction of the conductive material can be the diagonal direction. When the conductive material 200 is in a one-dimensional shape, the extension direction of the conductive material 200 can be the length direction.

In other words, the shape and the size of the microporous chamber 110 and the shape, size, density, and extension direction of the conductive material 200 can all affect the effective dielectric constant of the artificial dielectric material. The shape of the microporous chamber 110 is designed to be a first preset shape, the size of the microporous chamber 110 is designed to be a preset size, the shape of the conductive material 200 is designed to be a second preset shape, the size of the conductive material 200 is designed to be a preset size, the distribution density of the conductive material 200 is designed to be a preset density, the extension direction of the conductive material 200 is designed to be a preset extension direction, so that the effective dielectric constant of the artificial dielectric material can be designed to be a preset dielectric constant. When the lens unit 100 is made of artificial dielectric material with the preset dielectric constant, the electrical length of electromagnetic waves radiated by the feed unit 300 at any angle into the lens unit 100 can be changed. In this way, when the electromagnetic waves are emitted through the lens unit 100, all electromagnetic waves can form a parallel or nearly parallel beam, thereby achieving beam convergence, more concentrated energy, and higher gain.

The material of the substrate 10 has a relatively low relative dielectric constant of about 1.6. In addition, the substrate 10 is of a porous structure that is filled with air, and the relative dielectric constant of air is 1. Therefore, the effective dielectric constant of the substrate 10 in space is less than the dielectric constant of the material of the substrate 10. The conductive material 200 is disposed on the substrate 10, and the conductive material 200 is dispersedly disposed on side walls of the microporous chamber 110 of the substrate 10, which is equivalent to doping the conductive material 200 in the substrate 10, such that the effective dielectric constant of the artificial dielectric material can be increased to near the preset dielectric constant while ensuring that the weight will not increase significantly, and thus the artificial dielectric material with the preset dielectric constant can have higher gain. For example, after the conductive material 200 is "doped" in the substrate 10, the effective dielectric constant of the artificial dielectric material can be easily increased to 1 to 2 or higher, and the lens unit 100 made of the artificial dielectric material has a relatively light weight.

It can be understood that a large amount of conductive material 200 attached to the side walls of the microporous chamber 110 can be adjusted in size, distribution density, molding shape, a relative orientation relationship between the extension direction and the polarization direction of the dipole, etc., according to a lens design requirement, to achieve desired effective dielectric constants, and then obtain desired space radiation pattern performance, thereby solving the problem of low degree-of- freedom for the design of existing artificial dielectric materials.

Specifically, for example, when the metal is in a strip shape, reference can be made to a calculation formula of the effective dielectric constant of the artificial dielectric material:

$$\varepsilon = \varepsilon_0(1 + 7.85 \mathrm{N}'w^2)$$

$$(1)$$

where $\varepsilon_0$ is a vacuum dielectric constant, N' is the number of conductive materials 200 per unit cross-sectional space, w is the effective length of the conductive material 200 in the polarization direction of the dipole. The size and the shape of the conductive material 200 and the angle between the extension direction of the conductive material 200 and the polarization direction of the dipole of the feed unit 300 will all affect the value of w, and the distribution density of the conductive material 200 will affect the value of N'. In other words, the size, distribution density, and shape of the conductive material 200 and the angle between the extension direction of the conductive material 200 and the polarization direction of the dipole of the feed unit 300 will all affect the effective dielectric constant of the artificial dielectric material. In addition, the shape of the microporous chamber will affect the extension direction of the conductive material 200, and the size of the microporous chamber will affect the distribution density of the conductive material 200. In the present disclosure, the shape of the microporous chamber 110 is designed to be a first preset shape, the size of the microporous chamber is designed to be a first preset size, the shape of the conductive material 200 is designed to be a second preset shape, the size of the conductive material 200 is designed to be a second preset size, and the distribution density of the conductive material 200 is designed to be a preset density, such that the conductive material 200 has a higher equivalent length gain in the polarization direction of the dipole and a relatively larger number of conductive materials 200 per unit cross-sectional space.

The size of the conductive material 200 is adjusted according to the lens design requirement, which means that the electrical length of the conductive material 200 in the polarization direction of the dipole of the feed unit 300 is designed to be less than or equal to 1/20 wavelength of the center frequency of the frequency range supported by the feed unit 300. In this way, the conductive material 200 will not resonate but only generate an electric dipole moment and can be equivalent to the dielectric material, thereby achieving the effect of the lens unit 100. As such, a nearly parallel beam is formed by a radiation source on one side of the lens unit 100 after passing through the lens unit 100, thereby achieving maximum energy concentration.

For example, the electrical length of the conductive material 200 in the polarization direction of the dipole of the feed unit 300 is designed to be less than 1/20 wavelength, and the distribution density of the conductive material 200 is designed to be dense, which is equivalent to a lens unit 100 with a dielectric constant of 1-2. The electrical length of the conductive material 200 in the polarization direction of the dipole of the feed unit 300 is designed to be close to or equal to 1/20 wavelength, and the distribution density of the conductive material 200 is designed to be sparse, which is equivalent to a lens unit 100 with a dielectric constant of 1-2. The electrical length of the conductive material 200 in the polarization direction of the dipole of the feed unit 300 is designed to be close to or equal to 1/20 wavelength, and the distribution density of the conductive material 200 is designed to be dense, which is equivalent to a lens unit 100 with a dielectric constant of 1-2 or even higher.

The adjustment of the relative orientation relationship between the extension direction of the conductive material 200 on the side walls of the microporous chamber 110 and the polarization direction of the dipole can lead to different effective dielectric constants, thereby achieving the desired space radiation pattern performance. In other words, the beam (gain or width) of the lens antenna 1000 provided in the present disclosure can change as the angle between the extension direction of the conductive material 200 and the polarization direction of the dipole of the feed unit 300 changes. When the extension direction of the conductive material 200 changes, the change of the electrical length of the conductive material 200 in the polarization direction of the dipole leads to the change of the effective dielectric constant of the lens unit 100, thereby resulting in the change of the beam (gain or width) of the lens antenna 1000. When the effective dielectric constant of the lens unit 100 is equal to or close to the preset dielectric constant, the lens antenna 1000 generates a nearly parallel beam. In this case, beam gain increases greatly, beam width decreases greatly, and the beam is relatively narrow and long, such that the beam can be applicable to signal coverage in narrow and long areas such as high-speed railways, highways, rivers, or tunnels, or applicable to signal coverage in large stadiums, densely populated residential areas, maritime regions, or other scenarios requiring high gain. When the effective dielectric constant of the lens unit 100 is much less than the preset dielectric constant, the beam gain of the lens antenna 1000 increases less, the beam width decreases less, the beam is relatively wide, and the signal coverage distance is relatively short, such that the beam can be applicable to places with a small number of terminal connections and a small amount of data transmission while saving the antenna power consumption.

The relative orientation relationship between the conductive material 200 on the side walls of the microporous chamber 110 and the polarization direction of the dipole of the feed unit 300 is adjusted. In other words, the angle between the extension direction of the conductive material 200 on the side walls of the microporous chamber 110 and the polarization direction of the dipole of the feed unit 300 is adjusted.

Optionally, the angle between the extension direction of the conductive material 200 and the polarization direction of the dipole of the feed unit 300 is adjustable.

In an optional embodiment, an angle of the lens unit 100 is adjustable, such that the extension direction of the conductive material 200 can be changed, and further the effective induction electrical length of the conductive material 200 in the polarization direction of the dipole can be changed.

In this embodiment, reference can be made to FIG. 6, the lens unit 100 is of a rotatable structure (can rotate around a perpendicular bisector L1 of the feed unit 300), and the feed unit 300 has a relatively fixed position. Further, the lens antenna 1000 includes a first rotatable drive structure 50 and a first drive motor 40. One end of the first rotatable drive structure 50 is connected to an output shaft of the first drive motor 40, the other end of the first rotatable drive structure 50 is electrically connected to the lens unit 100, and the first rotatable drive structure 50 is driven by the first drive motor 40 to rotate, so as to drive the lens unit 100 to rotate around the perpendicular bisector L1 of the feed unit 300.

By adjusting a rotation angle of the lens unit 100, the extension direction of the conductive material 200 on the side walls of the microporous chamber 110 of the lens unit 100 can be adjusted. For example, the extension direction of the conductive material 200 is adjusted from being the same as the polarization direction of the dipole to being intersected with the polarization direction of the dipole or to being perpendicular to the polarization direction of the dipole, and then the effective dielectric constant of the lens unit 100 is adjusted to be close to or equal to the preset dielectric constant. In this way, a relatively narrow and long beam can be formed to be applicable to signal coverage in narrow and long areas such as high-speed railways, highways, rivers, or tunnels, or to be applicable to signal coverage in large stadiums, densely populated residential areas, maritime regions, or other scenarios requiring high gain. Alternatively, the effective dielectric constant of the lens unit 100 is adjusted to be much less than the preset dielectric constant. In this way, a relatively wide and short beam can be formed to be applicable to places with a small number of terminal connections and a small amount of data transmission while saving the antenna power consumption. The above realizes the reconfiguration of the radiation pattern.

In another optional embodiment, an angle of the feed unit 300 is adjustable, such that the polarization direction of the dipole of the feed unit 300 can be changed, and further the (effective induction) electrical length of the conductive material 200 in the polarization direction of the dipole can be changed.

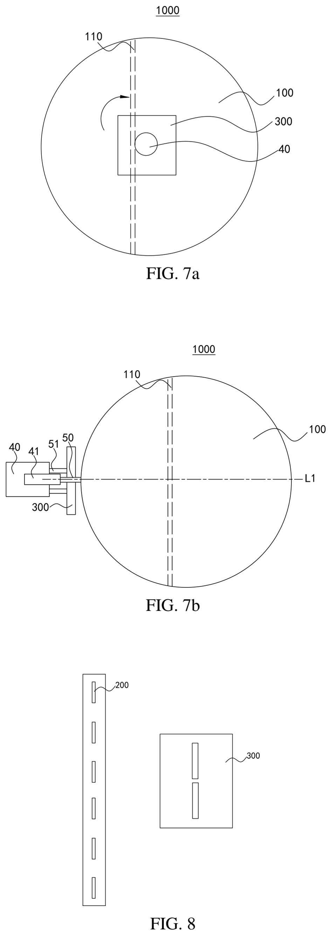

In this embodiment, reference can be made to FIG. 7a, the feed unit 300 is of a rotatable structure (can rotate around the perpendicular bisector L1 of the feed unit 300), and the lens unit 100 has a relatively fixed position. Further, the lens antenna 1000 includes a first rotatable drive structure 50 and a first drive motor 40. One end of the first rotatable drive structure 50 is connected to an output shaft of the first drive motor 40, the other end of the first rotatable drive structure 50 is electrically connected to the feed unit 300, and the first rotatable drive structure 50 is driven by the first drive motor 40 to rotate, so as to drive the feed unit 300 to rotate around the perpendicular bisector L1 of the feed unit 300.

By adjusting a rotation angle of the feed unit 300, the angle between the extension direction (of the maximum effective induction electrical length) of the conductive material 200 and the polarization direction of the dipole of the feed unit 300 is adjusted. For example, the extension direction (of the maximum effective induction electrical length) of the conductive material 200 is adjusted from being the same as the polarization direction of the dipole to being intersected with the polarization direction of the dipole or to being perpendicular to the polarization direction of the dipole, and then the effective dielectric constant of the lens unit 100 is adjusted to be close to or equal to the preset dielectric constant. In this way, a relatively narrow and long beam can be formed to be applicable to signal coverage in narrow and long areas such as high-speed railways, highways, rivers, or tunnels, or to be applicable to signal coverage in large stadiums, densely populated residential areas, maritime regions, or other scenarios requiring high gain. Alternatively, the effective dielectric constant of the lens unit 100 is adjusted to be much less than the preset dielectric constant. In this way, a relatively wide and short beam can be formed to be applicable to places with a small number of terminal signal connections and a small amount of data transmission while saving the antenna power consumption.

In yet another optional embodiment, reference can be made to FIG. 7b, an angle of the lens unit 100 is adjustable, and an angle of the feed unit 300 is adjustable, such that the extension direction (of the maximum effective induction electrical length) of the conductive material 200 can be changed, and the polarization direction of the dipole of the feed unit 300 can be changed, thereby changing the (maximum effective induction) electrical length of the conductive material 200 in the polarization direction of the dipole.

In this embodiment, both the lens unit 100 and the feed unit 300 are of rotatable structures (can rotate around the perpendicular bisector L1 of the feed unit 300). Further, reference can be made to FIG. 7b, the lens antenna 1000 includes a first rotatable drive structure 50, a first drive motor 40, a second rotatable drive structure 51, and a second drive motor 41. One end of the first rotatable drive structure 50 is connected to an output shaft of the first drive motor 40, and the other end of the first rotatable drive structure 50 is electrically connected to the lens unit 100, and the first rotatable drive structure 50 is driven by the first drive motor 40 to rotate, so as to drive the lens unit 100 to rotate around the perpendicular bisector L1 of the feed unit 300. One end of the second rotatable drive structure 51 is connected to an output shaft of the second drive motor 41, the other end of the second rotatable drive structure 51 is electrically connected to the feed unit 300, and the second rotatable drive structure 51 is driven by the second drive motor 41 to rotate, so as to drive the feed unit 300 to rotate around the perpendicular bisector L1 of the feed unit 300.

Certainly, in other embodiments, the angle between the extension direction of the conductive material 200 of the lens antenna 1000 and the polarization direction of the dipole of the feed unit 300 is relatively fixed.

Reference can be made to FIG. 1 to FIG. 27, the artificial dielectric material provided in the first aspect of embodiments of the present disclosure has a porous structure with microporous chambers 110, is stable and reliable, does not deform after long-term use, is acid-resistant, waterproof, and flame-retardant, and has a density of less than 30kg/m$^3$. The conductive material 200 will not fall off, and a relative position between the conductive materials 200 is fixed, such that the conductive materials 200 will not contact with one another, and an intermodulation indicator of the base station antenna will not be affected. In addition, this design can be mass-produced through honeycomb process as well as metal screen printing, metal printing, metal etching, or other processes, thereby solving the problem of poor manufacturability of existing artificial dielectric materials.

In some embodiments of the present disclosure, reference can be made to FIG. 1 to FIG. 3, the shape of each microporous chamber 110 is a hexagonal honeycomb, such that the substrate 10 is configured as a honeycomb structure. In other embodiments, the shape of the microporous chambers 110 is polygonal, circular, elliptical, or irregular two-dimensional. In other embodiments, at least two microporous chambers 110 have the same shape, or all of the microporous chambers 110 have different shapes. "Polygonal" includes, but is not limited to, triangular, quadrilateral, rhombic, etc.

In some embodiments of the present disclosure, the substrate 10 is made of aramid paper. It can be understood that the substrate 10 of the artificial dielectric material is made of aramid paper, the aramid paper is a lightweight and flame-retardant material that complies with the requirement of the base station antenna product for the fire rating of raw materials. Moreover, the aramid paper is also moisture-resistant and has high bearing strength and strong weather resistance, and thus fully meets the requirement of the base station antenna for the weather resistance of raw materials. Therefore, the aramid paper can be ensured to be normally used for over 10 years in outdoor environments ranging from -55°C to +75°C. In other embodiments, the substrate 10 is made of engineering plastics or flexible printed circuit (FPC) or the like.

In some embodiments of the present disclosure, the conductive material 200 is configured as multiple metal patterns, and at least one of the size, shape, or extension direction of each of the multiple metal patterns or space between adjacent metal patterns is adjusted to obtain desired effective dielectric constants. In some embodiments, a large number of rectangular metal strips are printed on the honeycomb microstructure, and the number of metal strips attached to the side walls of the honeycomb can be adjusted according to the required effective dielectric constant.

In some embodiments of the present disclosure, reference can be made to FIG. 4, and the metal patterns are uniformly distributed. In other embodiments, the metal patterns are not uniformly distributed. It can be understood that a large number of metal strips attached to the side walls of the honeycomb microstructure may be uniformly distributed or not uniformly distributed.

In some embodiments of the present disclosure, reference can be made to FIG. 4, and the long side direction of each metal pattern is the same as the polarization direction of the polarized dipole.

In some other embodiments, the long side direction of at least one metal pattern is disposed at a preset angle with the polarization direction of the polarized dipole.

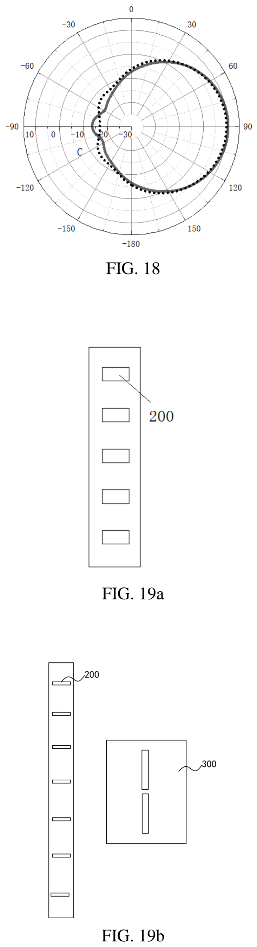

It can be understood that, reference can be made to FIG. 19a to FIG. 25b, long sides of a large number of metal strips attached to the side walls of the honeycomb structure may be completely consistent, partially consistent, or even at any angle with the polarization direction of the polarized dipole of the base station antenna.

In some embodiments of the present disclosure, the conductive material 200 is silver paste. It can be understood that the metal patterns attached to the side walls of the honeycomb structure are fixed by means of metal screen printing, and the raw material of the metal strips is silver paste. In other embodiments, metal screen printing can also be replaced by other metallization processes (metal printing, metal etching, etc.), and the raw material of the metal strips can also be other conductive materials (gold, copper, tin, etc.).

Reference can be made to FIG. 1 to FIG. 27, and the lens unit 100 provided in the second aspect of embodiments of the present disclosure includes the artificial dielectric material provided in the first aspect of embodiments of the present disclosure.

In some embodiments of the present disclosure, the lens unit 100 is configured as a three-dimensional structure. Preferably, the lens unit 100 is spherical in structure. Specifically, the diameter of the sphere is generally selected to be 5 cm to 100 cm, or can be any size that meets the design objective of the lens antenna 1000. In other embodiments, the lens unit 100 can be a cuboid, cubic, ellipsoidal, cylindrical, or irregular three-dimensional body.

Reference can be made to FIG. 1 to FIG. 27, and the fabrication method for the lens unit 100 provided in the third aspect of embodiments of the present disclosure can be the fabrication method for the lens unit 100 provided in the second aspect of embodiments of the present disclosure. The method includes the following steps. The substrate 10 is provided, and the substrate 10 is cut to an appropriate size. The conductive materials 200 are arranged on the substrate 10, where a molding shape, size, and distribution density of the conductive materials 200 are adjusted according to a lens design requirement during the arrangement, to achieve desired effective dielectric constants. The substrate 10 is formed into a porous structure by means of a honeycomb preparation process, where the conductive materials 200 are arranged on the side walls of the microporous chamber 110. The substrate 10 is processed into the lens unit 100.

It can be understood that the aramid paper is first cut to an appropriate size, subsequently printed with a certain number of metal strips, and then goes through a series of honeycomb production processes, to produce a raw material with a honeycomb structure for secondary processing by mechanical equipment into a specific three-dimensional lens unit 100 for use.

It can be understood that, based on the Effective Medium Theory, by distributing metal strips of a certain density in a certain spatial region, the dielectric constant of natural medium can be effectively represented. Specifically, an aramid paper-based hexagonal microstructure is used, and the metal strips of a certain density are attached to the side walls of the microstructure through metal screen printing or other processes, so as to obtain a desired effective dielectric constant.

According to the principle of ray tracing or other methods, the gain and beam width of a desired radiation pattern are designed, and then the size of the spherical lens with a certain dielectric constant is determined. This process can be simulated through electromagnetic simulation software. According to the theory and the simulation results, the fabrication process of the honeycomb aramid paper is used for physical processing, and then the accuracy of the simulation data is tested and verified.

In some embodiments of the present disclosure, the conductive materials 200 are formed into the metal patterns by metal screen printing, and the metal patterns are attached to the side walls of the microporous chambers 110. It can be understood that a certain number of metal patterns attached to the side walls of the honeycomb microstructure are rectangular thin metal strips each with a thickness of 5 um to 10 um, or other thicknesses designed according to actual requirements. The shape of the metal strips can also be square, circular, elliptical, or even any shape. The thickness of the metal strip can also be increased, and thus the metal strips can be a cuboid, cubic, ellipsoidal, cylindrical, or any three-dimensional metal body.

Reference can be made to FIG. 1 to FIG. 27, a lens antenna 1000 is provided in the fourth aspect of embodiments of the present disclosure, and the lens antenna 1000 can be a lens base station antenna. The lens antenna 1000 includes the lens unit 100 and the feed unit 300 provided in the second aspect of embodiments of the present disclosure. The feed unit 300 is fixed in spatial position relative to the lens unit 100.

It can be understood that, reference can be specifically made to FIG. 5 and FIG. 15 to FIG. 17, the lens antenna 1000 includes a spherical aramid paper-based artificial dielectric lens unit 100 with a honeycomb structure, a base station antenna dipole feed unit 300, and some other auxiliary connecting parts. The spherical aramid paper-based artificial dielectric lens unit 100 with the honeycomb structure is made of an aramid paper-based artificial dielectric material with the hexagonal honeycomb microstructure and has a spherical appearance. The base station antenna dipole feed unit 300 forms a structural entity with the spherical lens unit 100 through some other auxiliary connecting parts. Specifically, the feed unit 300 is fixed to the edge of the lens unit 100 through the auxiliary connecting parts.

In some embodiments of the present disclosure, a polarized manner of the feed unit 300 is orthogonal dual-linear polarization. In other embodiments, the polarized manner can be elliptical polarization, circular polarization, or other polarizations.

In some embodiments of the present disclosure, a beam of an artificial dielectric lens is a single beam, and the feed is in a single-frequency range. A relative position of the feed and the aramid paper-based lens unit 100 can be changed, to obtain different radiation patterns. Further, the feed can be disposed outside or inside the lens unit, to obtain a specific radiation pattern. Further, the number of feeds may be more than one, or multiple.

In this embodiment, the lens unit 100 may be spherical, cylindrical, etc. For illustrative purposes, the spherical lens unit 100 is taken as an example.

Reference can be made to FIG. 8, in the first embodiment, the feed unit 300 is a single-polarized antenna, that is, the feed unit 300 includes a symmetrical dipole, and the dipole has one polarization direction. The conductive material 200 is of a long-strip structure (or a linear structure).

Reference can be made to FIG. 4, the conductive material 200 is of a one-dimensional structure, such as a metal strip, and the extension direction of the metal strip is parallel to the axis of the microporous chamber.

Reference can be made to FIG. 8, the feed unit 300 includes a single-polarized dipole, and the extension direction (long side direction) of the conductive material 200 is the same as or at a small angle with the polarization direction of the polarized dipole. In other words, the length of the conductive material 200 in the long side direction is close to or equal to the maximum effective induction length of the conductive material 200 in the polarization direction of the dipole. According to Formula (1), w in the conductive material 200 provided in this embodiment has the maximum value. In other words, the conductive material 200 contributes greatly to the improvement of the effective dielectric constant of the lens unit 100, and thus the effective dielectric constant of the lens unit 100 can be greatly improved with a relatively short length of the conductive material 200. In this way, the number of the conductive material 200 per unit space can be increased, and the value of N' in Formula (1) can be increased, such that the lens unit 100 can have a relatively small size and light weight while the requirement of increasing the effective dielectric constant of the lens unit 100 to the preset effective dielectric constant is satisfied.

For example, the long side direction of the conductive material 200 is the axial direction of the microporous chamber, and the polarization direction of the polarized dipole of the feed unit 300 is also the axial direction of the microporous chamber.

The angle between the extension direction of the conductive material 200 and the polarization direction of the dipole of the feed unit 300 may be adjustable or non-adjustable.

Reference can be made to FIG. 8. This embodiment is combined with three adjustable angles between the extension direction of the conductive material 200 and the polarization direction of the dipole of the feed unit 300 mentioned in embodiments of the present disclosure. In this embodiment, the angle between the extension direction of the conductive material 200 and the polarization direction of the dipole of the feed unit 300 can be adjusted to a first angle range, where the first angle range includes 0° and values close to 0°. For example, the first angle range is [0°~ $n$°), and $n$ can be a value between 5 and 30. In the first angle range, the conductive material 200 has the maximum gain in improving the effective dielectric constant of the lens unit 100, which is conducive to forming a lens unit 100 with a dielectric constant close to or equal to the preset dielectric constant. As such, a first beam with a relatively narrow width, relatively strong directivity, and relatively great gain can be formed to be applicable to signal coverage in narrow and long areas such as high-speed railways, highways, rivers, or tunnels, or to be applicable to signal coverage in large stadiums, densely populated residential areas, maritime regions, or other scenarios requiring high gain.

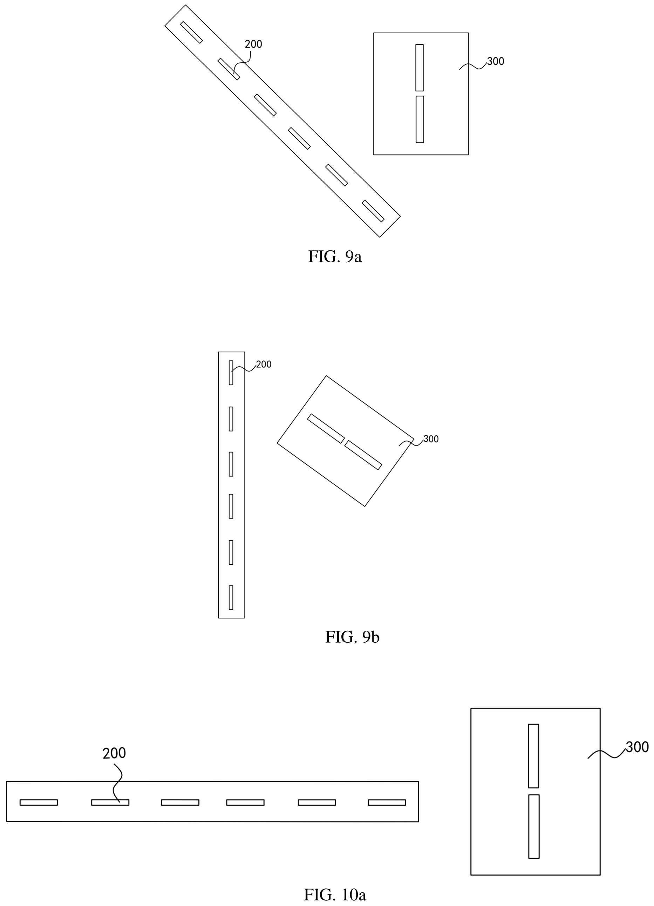

Reference can be made to FIG. 9a and FIG. 9b. In this embodiment, the angle between the extension direction of the conductive material 200 and the polarization direction of the dipole of the feed unit 300 can also be adjusted to a second angle range, where the second angle range includes 45° and values close to 45°. For example, the second angle range is $[n° \sim 45° \sim m°)$, and $m$ can be a value between 45 and 60. In the second angle range, the conductive material 200 has a relatively great gain in improving the effective dielectric constant of the lens unit 100, which is conducive to forming a second beam. The width of the second beam is larger than the width of the first beam, the directivity of the second beam is less than the directivity of the first beam, and the gain of the second beam is less than the gain of the first beam.

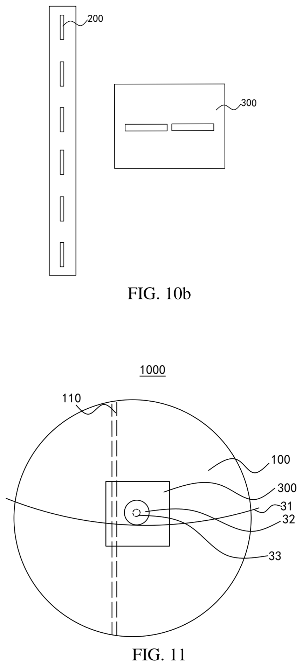

Reference can be made to FIG. 10a and FIG. 10b. In this embodiment, the angle between the extension direction of the conductive material 200 and the polarization direction of the dipole of the feed unit 300 can also be adjusted to a third angle range, where the third angle range includes 90° and values close to 90°. For example, the third angle range is $[m° \sim 90°]$, and $m$ can be a value between 60 and 90. In the third angle range, the conductive material 200 has a relatively great gain in improving the effective dielectric constant of the lens unit 100, which is conducive to forming a third beam. The width of the third beam is larger than the width of the second beam, the directivity of the third beam is less than the directivity of the second beam, and the gain of the third beam is less than the gain of the second beam. As such, a relatively wide beam with relatively weak directivity can be formed to be applicable to places with a small number of terminal signal connections and a small amount of data transmission while saving the antenna power consumption.

Certainly, in this embodiment, the first angle range, the second angle range, and the third angle range can be switched. Alternatively, the first angle range and the third angle range can be switched, for example, 0° and 90° can be switched.

Reference can be made to FIG. 11. In the second embodiment, based on the first embodiment, the feed unit 300 can rotate around the lens unit 100 in an equatorial plane of the lens unit 100. Specifically, the lens antenna 1000 further includes a first curved track 31, a third drive motor 32, and a third drive structure 33 (driven by the third drive motor 32). The first curved track 31 is disposed along the equatorial plane. The third drive structure 33 is connected to the third drive motor 32 and the feed unit 300. The third drive motor 32 drives the feed unit 300 to rotate around the lens unit 100 in the equatorial plane, thereby realizing beam scanning. The first curved track 31 is a curved tooth, and the third drive structure 33 is a gear meshing with the first curved track 31.

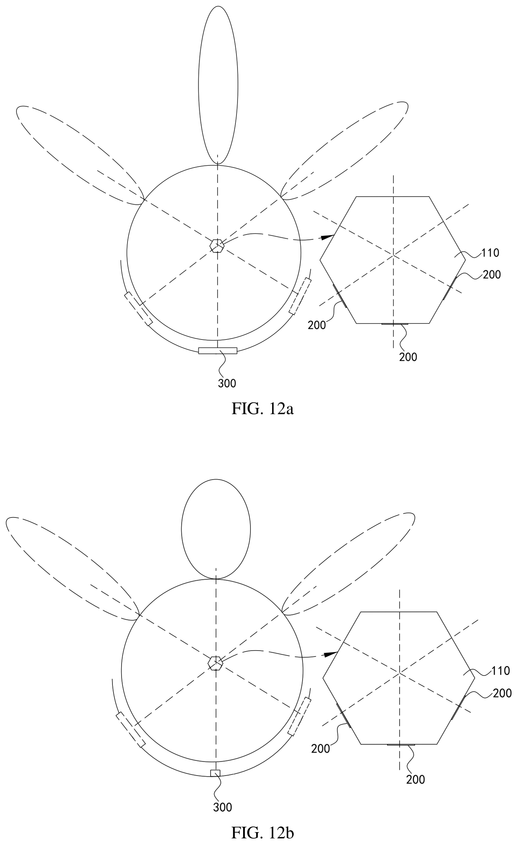

For example, reference can be made to FIG. 12a, multiple conductive materials 200 are disposed on all side walls of the microporous chamber 110, and the third drive motor 32 drives the feed unit 300 to move to different positions, to achieve horizontal scanning of the high-gain beam. For example, after the lens unit 100 is configured, the original horizontal beam width of the feed unit 300 is reduced from 65° to 33° (ellipses in FIG. 12a are schematic diagrams of the beam), and the feed unit 300 can be driven (e.g., by the third drive motor 32 in FIG. 11) to move to different positions, to ensure that the feed unit 300 can have a wider coverage range. In other embodiments, the position of the feed unit 300 can be configured to be fixed, and the position of the lens unit 100 changes relative to the position of the feed unit 300, to achieve beam scanning. In FIG. 12a, a feed unit 300 in solid line indicates a current position, a dashed block at an upper left corner of the feed unit 300 indicates a position (not limited to this position) where the feed unit 300 can move along the curve, and a dashed block at an upper right corner of the feed unit 300 indicates another position where the feed unit 300 can move along the curve. A solid-line beam in the middle of three elliptical beams is a beam formed after passing through the lens unit by the feed unit 300 at the current position. A dashed-line beam on the left of the three elliptical beams is a beam formed after passing through the lens unit by the feed unit 300 moving along the curve to the upper right corner. A dashed-line beam on the right of the three elliptical beams is a beam formed after passing through the lens unit by the feed unit 300 moving along the curve to the upper left corner.

FIG. 12a is a schematic diagram of three elliptical beams after being scaled down greatly. In actual applications, the three elliptical beams may be adjacent to, close to, or partially overlap with each other. The same is true for subsequent figures with multiple beams, which is not repeated herein.

In a specific application, optionally, reference can be made to FIG. 12b, the lens antenna 1000 provided in the present disclosure is also applicable to occasions such as a venue with a variable number of people, and the extension direction of the feed unit 300 and the position of the feed unit 300 can be adjusted according to the amount of data transmission. When there are fewer users in the venue, the amount of data transmission is small, and the feed unit 300 can rotate around the perpendicular bisector until the extension direction (long side direction) of the conductive material 200 is perpendicular or nearly perpendicular to the polarization direction of the polarized dipole, so as to form a wide beam covering a wider range, for example, covering 65°, to meet the needs of a small amount of data transmission when there are fewer users in the venue. Optionally, when there are crowded people in the venue, the amount of data transmission is large at this moment, and the feed unit 300 can rotate around the perpendicular bisector until the extension direction (long side direction) of the conductive material 200 is the same or nearly the same as the polarization direction of the polarized dipole, so as to form a narrower beam with great gain, for example, covering 33°, to meet the needs of a large amount of data transmission when there are crowded people in the venue (while the number of beams and carrier frequencies are increased).

In FIG. 12b, a feed unit 300 in solid line indicates a current position, a dashed block at an upper left corner of the feed unit 300 indicates a position (not limited to this position) where the feed unit 300 can move along the curve, and a dashed block at an upper right corner of the feed unit 300 indicates another position where the feed unit 300 can move along the curve. A solid-line beam in the middle of three elliptical beams is a beam formed after passing through the lens unit by the feed unit 300 at the current position. Since the direction (polarization direction) of the dipole of the feed unit 300 is perpendicular to the extension direction of the conductive material 200 at this moment, the beam is a wide beam. The feed unit 300 is able to rotate until the direction (polarization direction) of the dipole of the feed unit 300 is the same as the extension direction of the conductive material 200. A dashed-line beam on the left of the three elliptical beams is a beam formed after passing through the lens unit by the feed unit 300 moving along the curve to the upper right corner. A dashed-line beam on the right of the three elliptical beams is a beam formed after passing through the lens unit by the feed unit 300 moving along the curve to the upper left corner.

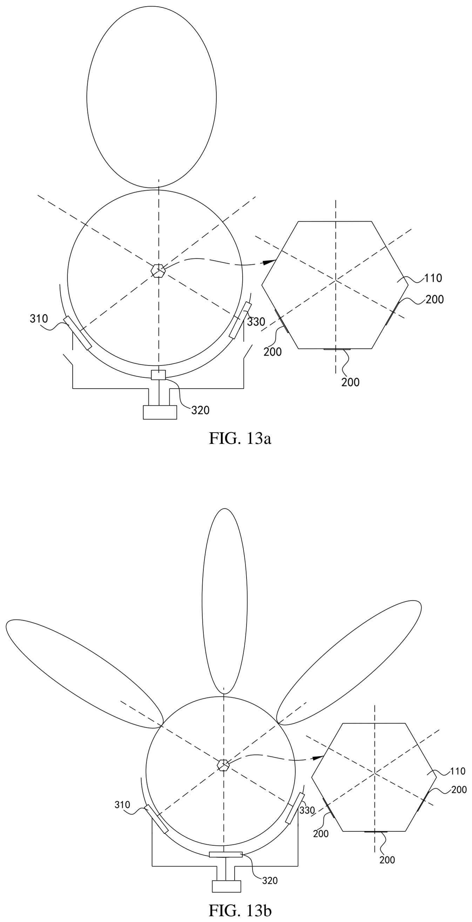

Reference can be made to FIG. 13a, in the third embodiment, different from the first embodiment, there are multiple feed units 300, and each feed unit 300 is disposed facing towards one surface of the microporous chamber 110. For example, there are two feed units 300, and the cross-section of the microporous chamber 110 is circular, triangular, square, rectangular, rhombic, etc.

Optionally, reference can be made to FIG. 13a, there are three feed units 300, and the cross-section of the microporous chamber 110 is triangular, hexagonal, etc.

For example, the cross-section of the microporous chamber 110 is hexagonal, and there are three feed units 300, namely, a first feed unit 310, a second feed unit 320, and a third feed unit 330. The first feed unit 310, the second feed unit 320, and the third feed unit 330 are disposed facing towards three different side walls of the microporous chamber 110, respectively. The angle between the extension direction of the conductive material 200 and the polarization direction of the dipole of at least one feed unit 300 is adjustable.

Reference can be made to FIG. 13a, in a specific application, optionally, the lens antenna 1000 provided in the present disclosure is also applicable to occasions such as a venue with a variable number of people, and the extension direction of the feed unit 300 and the number of operating feed units 300 can be adjusted according to the amount of data transmission. When there are fewer users in the venue, the amount of data transmission is small, and one or both of the first feed unit 310, the second feed unit 320, and the third feed unit 330 are operating, which can reduce the antenna power consumption. For example, a switch unit controls the second feed unit 320 in the middle to operate and controls the first feed unit 310 in the upper left corner and the third feed unit 330 in the upper right corner not to operate. The second feed unit 320 can rotate around the perpendicular bisector until the extension direction (long side direction) of the conductive material 200 is perpendicular or nearly perpendicular to the polarization direction of the polarized dipole, so as to form a wide beam covering a wider range, for example, covering 65°, to meet the needs of a small amount of data transmission when there are fewer users in the venue.

Reference can be made to FIG. 13b. Optionally, when there are crowded people in the venue, the amount of data transmission is large at this moment. In this case, all of the first feed unit 310, the second feed unit 320, and the third feed unit 330 are operating, and the polarization direction of a polarized dipole of the first feed unit 310 is the same or nearly the same as the extension direction (long side direction) of the conductive material 200, the polarization direction of a polarized dipole of the second feed unit 320 is the same or nearly the same as the extension direction (long side direction) of the conductive material 200, and the polarization direction of a polarized dipole of the third feed unit 330 is the same or nearly the same as the extension direction (long side direction) of the conductive material 200. As such, three adjacent narrower beams with great gain can be formed, for example, each beam covers 40°, to cover a horizontal width range of 120°, to meet the needs of a large amount of data transmission when there are locally crowded people in the venue.

For a place requiring 360° signal coverage, multiple groups of lens antennas 1000 can be disposed, to provide 360° signal coverage.

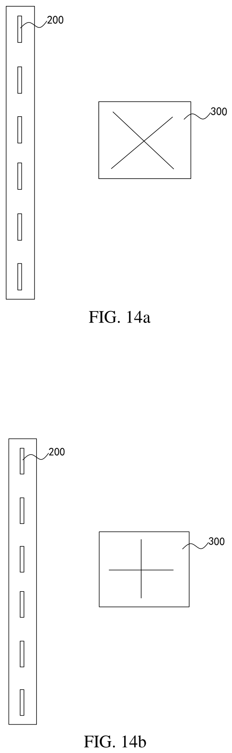

Reference can be made to FIG. 14a to FIG. 14b, in the fourth embodiment, different from the first embodiment to the third embodiment, the feed unit 300 includes a dual-polarized dipole. The feed unit 300 has two orthogonal polarization directions, specifically including but not limited to ±45° polarizations as well as vertical and horizontal polarizations.

In this embodiment, when there is only one feed unit 300, the lens unit 100 and the feed unit 300 are disposed to be rotatable relative to each other, to switch to a first state, i.e., the feed unit 300 includes a dual-polarized dipole, and the extension direction of the conductive material 200 and each of two polarization directions of the feed unit 300 are at an angle of 45°, or switch to a second state, i.e., the extension direction of the conductive material 200 is the same as one of the two polarization directions of the feed unit 300, or switch to a third state, i.e., the extension direction of the conductive material 200 is the same as the other of the two polarization directions of the feed unit 300.

When there are two or more feed units 300, each feed unit 300 can switch to the first state, the second state, or the third state.

Further, the feed unit 300 can also rotate around the lens unit 100 in the equatorial plane of the lens unit 100, thereby achieving beam scanning.

For the lens unit 100 provided in FIG. 4 and FIG. 5, an initial posture of the lens unit 100 can be determined according to different feed units 300. For example, in the first embodiment, the initial posture of the lens unit 100 is determined according to the extension direction (long side direction) of the conductive material 200 being the same as the polarization direction of the polarized dipole. In the first embodiment to the fourth embodiment, the initial posture of the lens unit 100 is determined according to the extension direction (long side direction) of the conductive material 200 and each of the two polarization directions of the polarized dipole being at an angle of 45°.

Further, several other embodiments are provided in combination with FIG. 19a to FIG. 25b.

Reference can be specifically made to FIG. 19a and FIG. 19b, in the fifth embodiment, the direction of the metal strips of the artificial dielectric lens is perpendicular to the honeycomb axial direction. The feed unit 300 is a single-polarized antenna. The extension direction of the metal strips is a direction that perpendicular to the axis of the microporous chamber 110.

The angle between the extension direction of the conductive material 200 and the polarization direction of the dipole of the feed unit 300 can be adjustable or non-adjustable. In an embodiment, when the angle is non-adjustable, a beam with a wider width and a relatively small gain is formed. In an embodiment, when the angle is adjustable, for the adjustment method, the adjustment manner, and the adjustment effect, reference can be made to those in the first embodiment.

Reference can be made to FIG. 11, in the sixth embodiment, based on the fifth embodiment, the feed unit 300 can rotate around the lens unit 100 in the equatorial plane of the lens unit 100. In this embodiment, reference can be roughly made to the third embodiment, and a difference between this embodiment and the third embodiment is as follows. In the third embodiment, when the position of the feed unit 300 is adjusted, since the length direction of the conductive material 200 is the axial direction of the microporous chamber 110, the conductive material 200 can always be kept parallel to or disposed facing towards the radiation surface of the feed unit 300 without rotating the feed unit 300 to be disposed facing towards the side walls of the microporous chamber 110.

Reference can be made to FIG. 12a and FIG. 12b. In this embodiment, since the length direction of the conductive material 200 is perpendicular to the axis of the microporous chamber 110, it's necessary to rotate the feed unit 300 to be disposed facing towards the side walls of the microporous chamber 110. If the cross-section of the microporous chamber 110 is hexagonal, the feed unit 300 can rotate to positions each disposed facing towards one of three adjacent side walls of the microporous chamber 110. In this way, the conductive material 200 can be parallel to or disposed facing towards the radiation surface of the feed unit 300, the conductive material 200 has a greater gain in increasing the effective dielectric constant, and a beam formed with good symmetry can be ensured.

Reference can be made to FIG. 13a and FIG. 13b, in the seventh embodiment, different from the fifth embodiment, there are multiple feed units 300, and each feed unit 300 is disposed facing towards one side wall of the microporous chamber 110.

For example, the cross-section of the microporous chamber 110 is hexagonal, and there are three feed units 300, namely, the first feed unit 310, the second feed unit 320, and the third feed unit 330. The first feed unit 310, the second feed unit 320, and the third feed unit 330 are disposed facing towards three different side walls of the microporous chamber 110, respectively. The angle between the extension direction of the conductive material 200 and the polarization direction of the dipole of at least one feed unit 300 is adjustable.

Reference can be made to FIG. 13a, in a specific application, optionally, the lens antenna 1000 provided in the present disclosure is also applicable to occasions such as a venue with a variable number of people, and the extension direction of the feed unit 300 and the number of operating feed units 300 can be adjusted according to the amount of data transmission. When there are fewer users in the venue, the amount of data transmission is small, and one or both of the first feed unit 310, the second feed unit 320, and the third feed unit 330 are operating, which can reduce the antenna power consumption. For example, the second feed unit 320 in the middle operates. When the second feed unit 320 is at the initial position, the extension direction (long side direction) of the conductive material 200 is perpendicular or nearly perpendicular to the polarization direction of the polarized dipole, so as to form a wide beam covering a wider range, for example, covering 65°, to meet the needs of a small amount of data transmission when there are fewer users in the venue.

Optionally, reference can be made to FIG. 13b. When there are crowded people in the venue, the amount of data transmission is large at this moment. In this case, all of the first feed unit 310, the second feed unit 320, and the third feed unit 330 are operating. The first feed unit 310 and/or the lens unit 100 rotates to make the polarization direction of the polarized dipole of the first feed unit 310 to be the same or nearly the same as the extension direction (long side direction) of the conductive material 200, the second feed unit 320 and/or the lens unit 100 rotates to make the polarization direction of the polarized dipole of the second feed unit 320 to be the same or nearly the same as the extension direction (long side direction) of the conductive material 200, and the third feed unit 310 and/or the lens unit 100 rotates to make the polarization direction of the polarized dipole of the third feed unit 330 to be the same or nearly the same as the extension direction (long side direction) of the conductive material 200. As such, three adjacent narrower beams with great gain can be formed, for example, each beam covers 40°, to cover the horizontal width range of 120°, to meet the needs of a large amount of data transmission when there are locally crowded people in the venue.

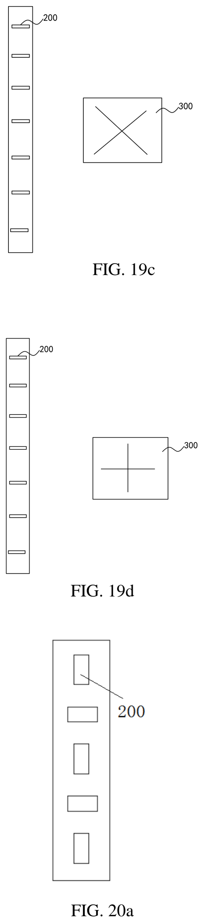

Reference can be made to FIG. 19c and FIG. 19d, in the eighth embodiment, different from the fifth embodiment to the seventh embodiment, the feed unit 300 includes a dual-polarized dipole. The feed unit 300 has two orthogonal polarization directions, specifically including but not limited to ±45° polarizations as well as vertical and horizontal polarizations.

In this embodiment, when there is only one feed unit 300, the lens unit 100 and the feed unit 300 are disposed to be rotatable relative to each other, to switch to the first state, i.e., the extension direction of the conductive material 200 and each of the two polarization directions of the feed unit 300 are at an angle of 45°, or switch to the second state, i.e., the extension direction of the conductive material 200 is the same as one of the two polarization directions of the feed unit 300, or switch to the third state, i.e., the extension direction of the conductive material 200 is the same as the other of the two polarization directions of the feed unit 300.

When there are two or more feed units 300, each feed unit 300 can switch to the first state, the second state, or the third state.

Further, the feed unit 300 can also rotate around the lens unit 100 in the equatorial plane of the lens unit 100, thereby achieving beam scanning.

Reference can be specifically made to FIG. 20a, in this embodiment, metal strips of the artificial dielectric lens have two orientations, where one of the two orientations is parallel to the axial direction of the microporous chamber 110, and the other of the two orientations is perpendicular to the axial direction of the microporous chamber 110. When the microporous chamber 110 is of a honeycomb structure, metal strips with one of the two orientations are parallel to the axial direction of the microporous chamber 110, and metal strips with the other of the two orientations are perpendicular to the axial direction of the microporous chamber 110. Reference can be specifically made to FIG. 20a, the metal strips with different orientations can be alternately disposed on the same side wall. Alternatively, metal strips with one orientation are disposed on one side wall, and metal strips with the other orientation are disposed on another side wall. Compared with the conductive material 200 with one extension direction, the present embodiment can be adapted to multiple feed units 300 with various polarization directions. Regardless of a feed unit 300 with any polarization direction, effective current along the polarization direction can be formed on the conductive material 200 of the lens unit 100, such that the effective dielectric constant of the lens unit 100 can be improved, and the beam gain of the feed unit 300 can be improved.

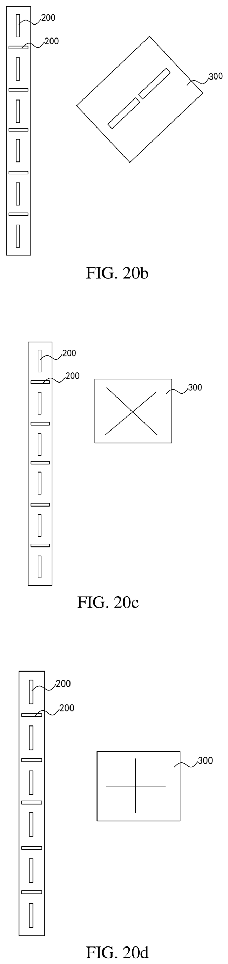

Reference can be specifically made to FIG. 20b, in the ninth embodiment, the feed unit 300 includes a single-polarized dipole. In the initial state, the polarization direction of the feed unit 300 is at an angle of 45° with metal strips with each of the two orientations, such that the metal strips with each of the two orientations have gain in the dielectric constant, and thus a beam after passing through the lens unit 100 by the feed unit 300 has good symmetry in the vertical direction and the horizontal direction. Certainly, the angle between the extension direction of the conductive material 200 and the polarization direction of the dipole of the feed unit 300 can be adjusted, such that the first beam or the second beam can be formed to be applicable to corresponding scenarios, respectively.

Reference can be specifically made to FIG. 11, FIG. 12a, and FIG. 12b, in the tenth embodiment, on the basis of the ninth embodiment, the feed unit 300 can rotate around the lens unit 100 in the equatorial plane of the lens unit 100. Optionally, the metal strips with one orientation are disposed on one side wall, and the metal strips with the other orientation are disposed on another side wall, so as to achieve beam reconstruction, for example, reconstruction from the first beam to the third beam or reconstruction from the third beam to the first beam.

Reference can be specifically made to FIG. 13a and FIG. 13b, in the eleventh embodiment, different from the ninth embodiment, there are multiple feed units 300, and each feed unit 300 is disposed facing towards one side wall of the microporous chamber 110.

Optionally, there are three feed units 300, and the cross-section of the microporous chamber 110 is triangular, hexagonal, etc.

For example, the cross-section of the microporous chamber 110 is hexagonal, and there are three feed units 300, namely, the first feed unit 310, the second feed unit 320, and the third feed unit 330. The first feed unit 310, the second feed unit 320, and the third feed unit 330 are disposed facing towards three different side walls of the microporous chamber 110, respectively. The angle between the extension direction of the conductive material 200 and the polarization direction of the dipole of at least one feed unit 300 is adjustable.

For another example, reference can be made to FIG. 12b, the lens unit 100 rotates to make the extension direction of the conductive material 200 to be nearly parallel to the polarization direction of the first feed unit 310 and the polarization direction of the third feed unit 330, and to make the extension direction of the conductive material 200 to be nearly perpendicular to the polarization direction of the second feed unit 320, such that a beam with great gain on both sides and a large width in the middle can be formed to be applicable to a scenario with a relatively large amount of transmission tasks on both sides and a relatively small amount of transmission tasks in the middle.

For yet another example, reference can be made to FIG. 13b, the polarization direction of the first feed unit 310 and the polarization direction of the third feed unit 330 are adjusted to be nearly parallel to the extension direction of the conductive material 200, such that a beam with a small width and a great gain in the middle and on both sides can be formed to be applicable to a scenario with a relatively large amount of transmission tasks in a relatively wide range.

Reference can be specifically made to FIG. 20c, in the twelfth embodiment, different from the ninth embodiment to the eleventh embodiment, the feed unit 300 includes a dual-polarized dipole. The feed unit 300 has two orthogonal polarization directions, specifically including but not limited to $\pm 45°$ polarizations as well as vertical and horizontal polarizations.

In the initial state, the polarization direction of the feed unit 300 is at an angle of 45° with metal strips with each of the two orientations, such that the beam after passing through the lens unit 100 by the feed unit 300 has good symmetry in the vertical direction and the horizontal direction. Certainly, the angle between the extension direction of the conductive material 200 and the polarization direction of the dipole of the feed unit 300 can be adjusted, such that the first beam or the second beam can be formed to be applicable to corresponding scenarios, respectively.

In this embodiment, when there is only one feed unit 300, the lens unit 100 and the feed unit 300 are disposed to be rotatable relative to each other to switch to the first state, i.e., in combination with FIG. 20c, the extension direction of the conductive material 200 and each of the two polarization directions of the feed unit 300 are at an angle of 45°, or switch to the second state, i.e., in combination with FIG. 20d, the extension direction of the conductive material 200 is the same as one of the two polarization directions of the feed unit 300, or switch to the third state, i.e., the extension direction of the conductive material 200 is the same as the other of the two polarization directions of the feed unit 300.

Further, there can be multiple feed units 300, and each feed unit 300 is disposed facing towards one surface of the microporous chamber 110. When there are two or more feed units 300, each feed unit 300 can switch to the first state, the second state, or the third state.

Further, the feed unit 300 can also rotate around the lens unit 100 in the equatorial plane of the lens unit 100, thereby achieving beam scanning.

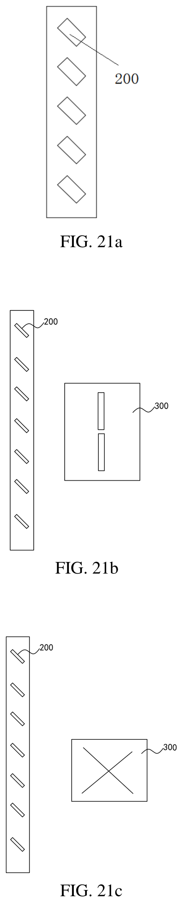

Reference can be specifically made to FIG. 21a, in this embodiment, the metal strips of the artificial dielectric lens are oriented at +45° relative to the honeycomb (microporous chamber 110) axis and have the same orientation.

Reference can be specifically made to FIG. 21b, in the thirteenth embodiment, the feed unit 300 is a single-polarized antenna, that is, the feed unit 300 includes a pair of symmetrical dipoles, and the dipoles have one polarization direction. The angle between the extension direction of the conductive material 200 and the polarization direction of the dipoles of the feed unit 300 is adjustable or non-adjustable.

In an embodiment, when the angle between the extension direction of the conductive material 200 and the polarization direction of the dipoles of the feed unit 300 is adjustable, the angle between the polarization direction of the dipoles is adjusted from along the axial direction of the microporous chamber 110 to along the extension direction of the conductive material 200, and the beam width and the beam gain can be adjusted through 45° rotation. The rotation angle is reduced, and the design requirement for the rotatable drive structure is reduced, making it easier to implement.

Reference can be specifically made to FIG. 11, FIG. 12a, and FIG. 12b, in the fourteenth embodiment, on the basis of the thirteenth embodiment, the feed unit 300 can rotate around the lens unit 100 in the equatorial plane of the lens unit 100. In this embodiment, since the length direction of the conductive material 200 is at an angle of 45° with the axial direction of the microporous chamber 110, the conductive material 200 has a certain effective induction length in the axial direction of the microporous chamber 110, and thus it is not necessary to rotate the feed unit 300 to be disposed facing towards the side walls of the microporous chamber 110, or to always keep the conductive material 200 to be parallel to or disposed facing towards the radiation surface of the feed unit 300. In other words, during the continuous rotation of the feed unit 300, current along the polarization direction of the feed unit 300 can be formed on the conductive material 200 under the coupling of the radiation field, thereby enabling the modification of the effective dielectric constant of the lens unit 100.

Reference can be specifically made to FIG. 13a and FIG. 13b, in the fifteenth embodiment, different from the thirteenth embodiment, there are multiple feed units 300, and each feed unit 300 is disposed facing towards one side wall of the microporous chamber 110.

For example, the cross-section of the microporous chamber 110 is hexagonal, and there are three feed units 300, namely, the first feed unit 310, the second feed unit 320, and the third feed unit 330. The first feed unit 310, the second feed unit 320, and the third feed unit 330 are disposed facing towards three adjacent side walls of the microporous chamber 110, respectively. The angle between the extension direction of the conductive material 200 and the polarization direction of the dipole of at least one feed unit 300 is adjustable.

Reference can be specifically made to FIG. 21c, in the sixteenth embodiment, different from the thirteenth embodiment to the fifteenth embodiment, the feed unit 300 includes a dual-polarized dipole. The feed unit 300 has two orthogonal polarization directions, specifically including but not limited to $\pm 45°$ polarizations as well as vertical and horizontal polarizations.

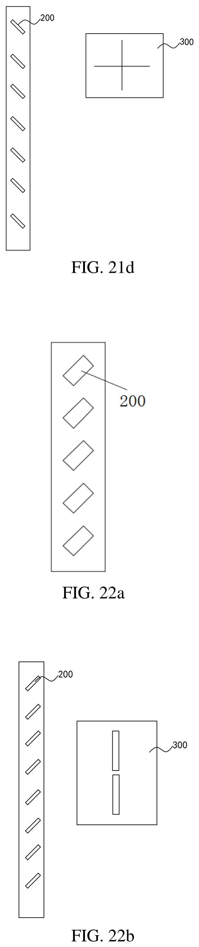

In this embodiment, when there is only one feed unit 300, the lens unit 100 and the feed unit 300 are disposed to be rotatable relative to each other to switch to the first state, i.e., in combination with FIG. 21c, the extension direction of the conductive material 200 and each of the two polarization directions of the feed unit 300 are at an angle of 45°, or switch to the second state, i.e., in combination with FIG. 21d, the extension direction of the conductive material 200 is the same as one of the two polarization directions of the feed unit 300, or switch to the third state, i.e., the extension direction of the conductive material 200 is the same as the other of the two polarization directions of the feed unit 300.

When there are two or more feed units 300, each feed unit 300 can switch to the first state, the second state, or the third state.

Further, the feed unit 300 can also rotate around the lens unit 100 in the equatorial plane of the lens unit 100, thereby achieving beam scanning.

Reference can be specifically made to FIG. 22a, in this embodiment, the metal strips of the artificial dielectric lens are oriented at -45° relative to the honeycomb (microporous chamber 110) axis and have the same orientation.

Reference can be specifically made to FIG. 22b, in the seventeenth embodiment, the feed unit 300 is a single-polarized antenna, that is, the feed unit 300 includes a pair of symmetrical dipoles, and the dipoles have one polarization direction. The angle between the extension direction of the conductive material 200 and the polarization direction of the dipoles of the feed unit 300 is adjustable or non-adjustable.

In an embodiment, when the angle between the extension direction of the conductive material 200 and the polarization direction of the dipoles of the feed unit 300 is adjustable, the angle between the polarization direction of the dipoles is adjusted from along the axial direction of the microporous chamber 110 to along the extension direction of the conductive material 200, and the beam width and the beam gain can be adjusted through 45° rotation. The rotation angle is reduced, and the design requirement for the rotatable drive structure is reduced, making it easier to implement.

Reference can be specifically made to FIG. 11, FIG. 12a, and FIG. 12b, in the eighteenth embodiment, based on the seventeenth embodiment, the feed unit 300 can rotate around the lens unit 100 in the equatorial plane of the lens unit 100. In this embodiment, since the length direction of the conductive material 200 is at an angle of 45° with the axial direction of the microporous chamber 110, the conductive material 200 has a certain effective induction length in the axial direction of the microporous chamber 110, and thus it is not necessary to rotate the feed unit 300 to be disposed facing towards the side walls of the microporous chamber 110, or to always keep the conductive material 200 to be parallel to or disposed facing towards the radiation surface of the feed unit 300. In other words, during the continuous rotation of the feed unit 300, current along the polarization direction of the feed unit 300 can be formed on the conductive material 200 under the coupling of the radiation field, thereby enabling the modification of the effective dielectric constant of the lens unit 100.

Reference can be specifically made to FIG. 13a and FIG. 13b, in the nineteenth embodiment, different from the seventeenth embodiment, there are multiple feed units 300, and each feed unit 300 is disposed facing towards one side wall of the microporous chamber 110.

For example, the cross-section of the microporous chamber 110 is hexagonal, and there are three feed units 300, namely, the first feed unit 310, the second feed unit 320, and the third feed unit 330. The first feed unit 310, the second feed unit 320, and the third feed unit 330 are disposed facing towards three adjacent side walls of the microporous chamber 110, respectively. The angle between the extension direction of the conductive material 200 and the polarization direction of the dipole of at least one feed unit 300 is adjustable.

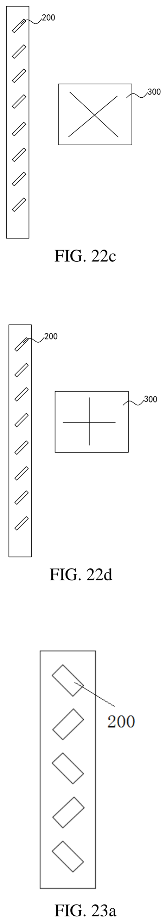

Reference can be specifically made to FIG. 22c, in the twentieth embodiment, different from the seventeenth embodiment to the nineteenth embodiment, the feed unit 300 includes a dual-polarized dipole. The feed unit 300 has two orthogonal polarization directions, specifically including but not limited to $\pm 45°$ polarizations as well as vertical and horizontal polarizations.

In this embodiment, when there is only one feed unit 300, the lens unit 100 and the feed unit 300 are disposed to be rotatable relative to each other to switch to the first state, i.e., in combination with FIG. 22c, the extension direction of the conductive material 200 and each of the two polarization directions of the feed unit 300 are at an angle of 45°, or switch to the second state, i.e., in combination with FIG. 22d, the extension direction of the conductive material 200 is the same as one of the two polarization directions of the feed unit 300, or switch to the third state, i.e., the extension direction of the conductive material 200 is the same as the other of the two polarization directions of the feed unit 300.

When there are two or more feed units 300, each feed unit 300 can switch to the first state, the second state, or the third state.

Further, the feed unit 300 can also rotate around the lens unit 100 in the equatorial plane of the lens unit 100, thereby achieving beam scanning.

Reference can be specifically made to FIG. 23a, in this embodiment, the metal strips of the artificial dielectric lens are alternately oriented at +45° and -45° relative to the honeycomb (microporous chamber 110) axis.

Compared with the conductive material 200 with one extension direction, the present embodiment can be adapted to multiple feed units 300 with various polarization directions. Regardless of a feed unit 300 with any polarization direction, effective current along the polarization direction can be formed on the conductive material 200 of the lens unit 100, such that the effective dielectric constant of the lens unit 100 can be improved, and the beam gain of the feed unit 300 can be improved.

Reference can be specifically made to FIG. 23b, in the twenty-first embodiment, the feed unit 300 includes a single-polarized dipole. In the initial state, the polarization direction of the feed unit 300 is at an angle of 45° with metal strips with each of the two orientations, such that the metal strips with each of the two orientations have gain in the dielectric constant, and thus the beam after passing through the lens unit 100 by the feed unit 300 has good symmetry in the vertical direction and the horizontal direction. Certainly, the angle between the extension direction of the conductive material 200 and the polarization direction of the dipole of the feed unit 300 can be adjusted, such that the first beam or the second beam can be formed to be applicable to corresponding scenarios, respectively.

Reference can be specifically made to FIG. 11, FIG. 12a, and FIG. 12b, in the twenty-second embodiment, on the basis of the twenty-first embodiment, the feed unit 300 can rotate around the lens unit 100 in the equatorial plane of the lens unit 100. Optionally, the metal strips with one orientation are disposed on one side wall, and the metal strips with the other orientation are disposed on another side wall, so as to achieve beam reconstruction, for example, reconstruction from the first beam to the third beam or reconstruction from the third beam to the first beam.

Reference can be specifically made to FIG. 13a and FIG. 13b, in the twenty-third embodiment, different from the twenty-first embodiment, there are multiple feed units 300, and each feed unit 300 is disposed facing towards one side wall of the microporous chamber 110.

Optionally, there are three feed units 300, and the cross-section of the microporous chamber 110 is triangular, hexagonal, etc.

For example, the cross-section of the microporous chamber 110 is hexagonal, and there are three feed units 300, namely, the first feed unit 310, the second feed unit 320, and the third feed unit 330. The first feed unit 310, the second feed unit 320, and the third feed unit 330 are disposed facing towards three different side walls of the microporous chamber 110, respectively. The angle between the extension direction of the conductive material 200 and the polarization direction of the dipole of at least one feed unit 300 is adjustable.

Further, optionally, in combination with FIG. 13b, an angle between a polarization direction of at least one of the first feed unit 310, the second feed unit 320, or the third feed unit 330 and the extension direction of the conductive material 200 is adjustable.

For example, the polarization direction of the second feed unit 320 is adjusted to be perpendicular to the extension direction of the conductive material 200, such that a beam with a large width in the middle and on both sides can be formed to be applicable to a scenario with a relatively small amount of transmission tasks in a relatively wide range.

For another example, in combination with FIG. 12b, the lens unit 100 rotates to make the extension direction of the conductive material 200 to be nearly parallel to the polarization direction of the first feed unit 310 and the polarization direction of the third feed unit 330, and to make the extension direction of the conductive material 200 to be nearly perpendicular to the polarization direction of the second feed unit 320, such that a beam with great gain on both sides and a large width in the middle can be formed to be applicable to a scenario with a relatively large amount of transmission tasks on both sides and a relatively small amount of transmission tasks in the middle.

For another example, in combination with FIG. 13b, the polarization directions of the first feed unit 310 and the polarization direction of the third feed unit 330 are adjusted to be nearly parallel to the extension direction of the conductive material 200, such that a beam with a small width and a great gain in the middle and on both sides can be formed to be applicable to a scenario with a relatively large amount of transmission tasks in a relatively wide range.

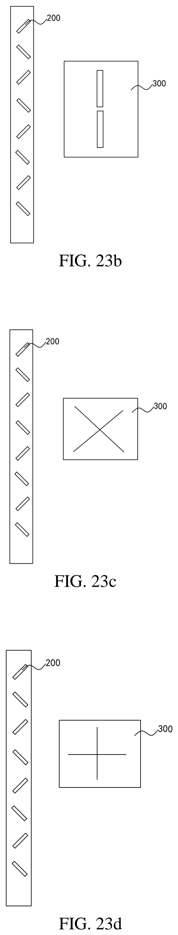

Reference can be specifically made to FIG. 23c, in the twenty-fourth embodiment, different from the twenty-first embodiment to the twenty-third embodiment, the feed unit 300 includes a dual-polarized dipole. The feed unit 300 has two orthogonal polarization directions, specifically including but not limited to ±45° polarizations as well as vertical and horizontal polarizations.

In the initial state, the polarization direction of the feed unit 300 is at an angle of 45° with metal strips with each of the two orientations, such that the beam after passing through the lens unit 100 by the feed unit 300 has good symmetry in the vertical direction and the horizontal direction. Certainly, the angle between the extension direction of the conductive material 200 and the polarization direction of the dipole of the feed unit 300 can be adjusted, such that the first beam or the second beam can be formed to be applicable to corresponding scenarios, respectively.

In this embodiment, when there is only one feed unit 300, the lens unit 100 and the feed unit 300 are disposed to be rotatable relative to each other, to switch to the first state, i.e., in combination with FIG. 23c, the extension direction of the conductive material 200 and each of the two polarization directions of the feed unit 300 are at an angle of 45°, or switch to the second state, i.e., in combination with FIG. 23d, the extension direction of the conductive material 200 is the same as one of the two polarization directions of the feed unit 300, or switch to the third state, i.e., the extension direction of the conductive material 200 is the same as the other of the two polarization directions of the feed unit 300.

Further, there can be multiple feed units 300, and each feed unit 300 is disposed facing towards one surface of the microporous chamber 110. When there are two or more feed units 300, each feed unit 300 can switch to the first state, the second state, or the third state.

Further, the feed unit 300 can also rotate around the lens unit 100 in the equatorial plane of the lens unit 100, thereby achieving beam scanning.

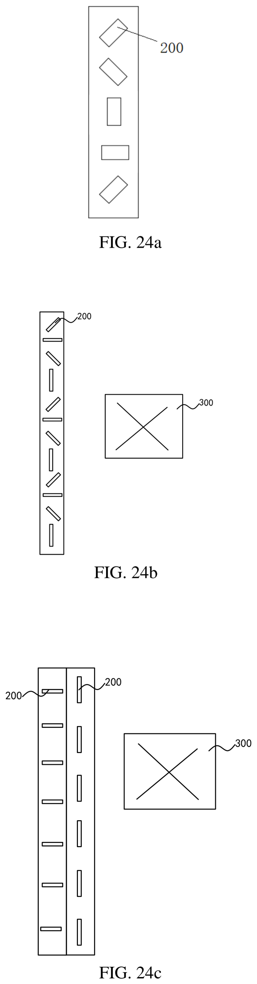

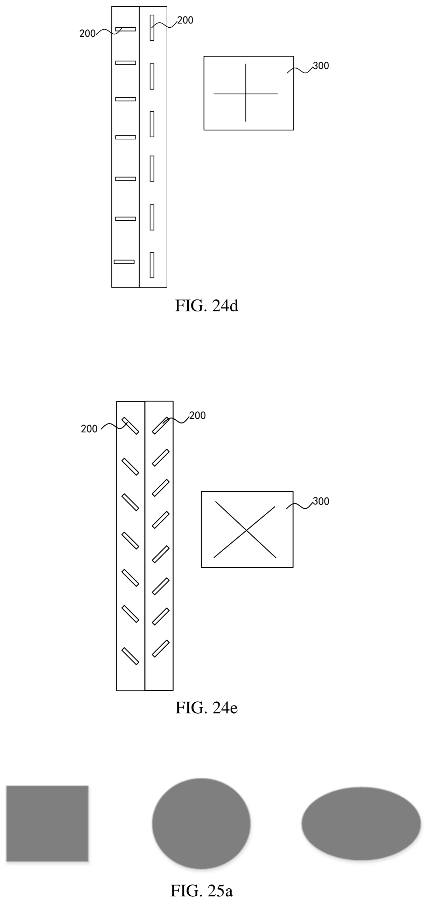

Reference can be specifically made to FIG. 24a and FIG. 24b, in this embodiment, the metal strips of the artificial dielectric lens are oriented at any angle relative to the honeycomb (microporous chamber 110) axis, and space between the metal strips is also random. In this embodiment, the extension direction of the conductive material 200 is multiple. Compared with the conductive material 200 with one or two extension directions, the conductive material 200 in this embodiment has more extension directions, such that the conductive material 200 can be consistent with polarization directions of feed units 300 with various rotation directions, and can be adapted to multiple feed units 300 with various polarization directions. Regardless of a feed unit 300 with any polarization direction, effective current with greater gain along the polarization direction can be formed on the conductive material 200 of the lens unit 100, such that the effective dielectric constant of the lens unit 100 can be improved, and the beam gain of the feed unit 300 can be improved. For the feed unit 300, the rotation direction of the feed unit 300 is configured more flexibly and unlimitedly.

Reference can be specifically made to FIG. 24a and FIG. 24b, when the conductive material 200 extends in one direction or two directions, the lens unit 100 has a certain selectivity for the feed unit 300, that is, gain improvement can be achieved for a beam of a feed unit 300 in a certain specific rotation direction. More extension directions of the conductive material 200 lead to weaker selectivity of the lens unit 100 for the feed unit 300, and gain improvement can be achieved for a beam of a feed unit 300 in any rotation direction.

In any embodiment, reference can be specifically made to FIG. 24c to FIG. 24e, each microporous chamber 110 has multiple side walls, extension directions of multiple conductive materials on each side wall are the same or different, and extension directions of multiple conductive materials on different side walls are the same or different. For example, an extension direction of the conductive materials 200 on one side wall is perpendicular to an extension direction of the conductive materials 200 on an adjacent side wall. For example, the extension direction of the conductive materials 200 on one side wall is along the axis of the microporous chamber 110, and the extension direction of the conductive materials 200 on the adjacent side wall is perpendicular to the axis of the microporous chamber 110. Alternatively, the extension direction of the conductive materials 200 on one side wall is along the axis of the microporous chamber 110, and the extension direction of the conductive materials 200 on the adjacent side wall is perpendicular to the axis of the microporous chamber 110.

Further, reference can be made to FIG. 25a, which illustrates different metal shapes. In addition to the rectangular shape, the metal shape can also be circular, elliptical, etc., all of which can be used in the artificial dielectric materials.

In other words, the conductive material 200 can also be of a two-dimensional structure. For example, the shape of the conductive material 200 can also be rectangular, circular, elliptical, cruciform, square, etc.

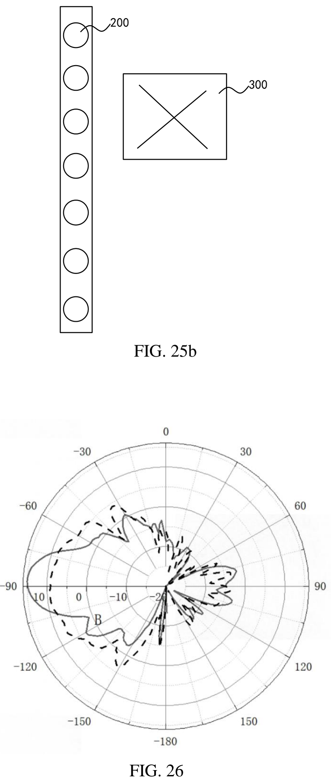

Reference can be specifically made to FIG. 25b, the feed unit 300 includes a dual-polarized dipole, the extension direction of the conductive material includes a first direction and a second direction, the first direction is the same as one of polarization directions of the feed unit 300, and the second direction is the same as the other of the polarization directions of the feed unit 300.

The conductive material 200 is of a two-dimensional structure and has an effective electrical length in at least two directions. For example, when the conductive material 200 is in a rectangular shape, the conductive material 200 has the effective electrical length in both the length direction and the width direction of the rectangular shape, such that the dual-polarized feed unit 300 along the length direction and the width direction of the conductive material 200 can have smaller beam width and greater beam gain in both the length direction and the width direction of the conductive material 200.

Optionally, the dual-polarized feed unit 300 can rotate around the lens unit 100 in the equatorial plane of the lens unit 100, thereby realizing beam scanning.

Optionally, there are multiple feed units 300, and each feed unit 300 is disposed facing towards one surface of the microporous chamber 110, such that multiple high-gain beams together cover a wider range.

It can be noted that with the continuous construction of commercial mobile communication networks, both coverage and high capacity are required for various signal coverage scenarios. At the same time, the coexistence of 3G, 4G, and 5G signals will become the norm for a considerable period. The electromagnetic wave frequencies are primarily four frequency ranges, i.e., 698~960 MHz, 1710~2690 MHz, 3.3~3.8 GHz, and 4.8~5.0 GHz. Therefore, in the present disclosure, the feed unit 300 operates at a frequency of 1710~2690 MHz, and the feed can also operate in different communication frequency ranges such as 698~960 MHz, 3.3~3.8 GHz, 4.8~5.0 GHz, etc. According to a desired maximum power direction of a space radiation pattern, the feed unit 300 can be arbitrarily moved along the edge of the lens structure within a 360° range.

In some embodiments of the present disclosure, the lens unit 100 is configured as a spherical shape. In order to minimize the overall antenna volume, the lens unit 100 is located directly above the feed unit 300, and the lens unit 100 and the feed unit 300 are seamlessly close to each other. In other embodiments, the lens unit 100 can be spaced apart from or wrapped around the dipole feed, to form various desired space radiation patterns.

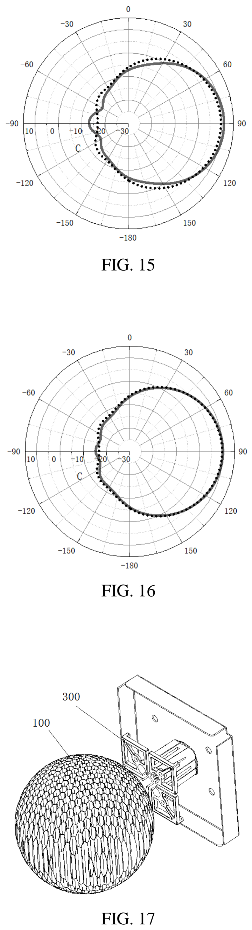

It can be understood that compared with the traditional linear array base station antenna, with reference to FIG. 15, FIG. 16, FIG. 18, FIG. 26, and FIG. 27, the lens base station antenna provided in the present disclosure can obtain a space radiation pattern with greater gain without requiring multiple array units and complex feed networks, and the elevation plane of the radiation pattern can be designed to be relatively wide, which is used for uniform coverage of communication signals in a long-strip and long-distance area or other areas. Since the aramid paper-based honeycomb structure has a low density and the entire antenna has only one lens unit 100 and one feed dipole unit, the base station antenna provided in the present disclosure has a smaller size and light weight, and thus the base station antenna is more suitable for engineering installation in actual network construction, and the simple and compact structure is also more suitable for large-scale production in the industry.

Reference can be specifically made to FIG. 1, which is a top view of a spherical lens made of the artificial dielectric material provided in the present disclosure, viewed along an axis of a honeycomb micro-unit, and all microstructures are in a honeycomb shape.

Reference can be specifically made to FIG. 2 and FIG. 3, which are subunits of a honeycomb artificial dielectric lens structure. Metal strips are attached to walls of the structure. Since each metal strip has a long side and a short side, there is an orientation direction of the long side.

Reference can be specifically made to FIG. 4, FIG. 15, and FIG. 16, an embodiment is provided. A feed is a dual-polarized dipole subunit of 1.7-2.7 GHz, a lens is a unit with a diameter of 10 cm, and corresponding simulation results at a frequency of 2.2 GHz are given.

Reference can be specifically made to FIG. 4, which is a schematic diagram illustrating distribution of metal strips on one of side walls of a honeycomb structure. Reference can be specifically made to FIG. 5, which is a schematic diagram of a relative structure of a dual-polarized feed and a honeycomb artificial dielectric lens sphere. In this example, one of polarizations of the dual-polarized feed is consistent with the long side direction of the metal strip, and the other of the polarizations is perpendicular to the long side direction of the metal strip. Reference can be specifically made to FIG. 15, which illustrates changes in an elevation-plane radiation pattern of a dipole with a polarization direction consistent with the orientation of the metal strip with and without the additional lens. The dashed line is the case of a single dipole, and the solid line is the result with the additional lens. The elevation-plane radiation pattern becomes narrower, and the gain is significantly improved. Reference can be specifically made to FIG. 16, which illustrates changes in an elevation-plane radiation pattern of a dipole with a polarization direction perpendicular to the orientation of the metal strip with and without the additional lens. The dashed line is the case of a single dipole, and the solid line is the result with the additional lens. The elevation-plane radiation pattern becomes narrower, and the gain is slightly improved. As can be seen from FIG. 15 and FIG. 16, when the polarization direction is consistent with the long side direction of the metal strip, a greater gain can be obtained.

Reference can be specifically made to FIG. 17, which illustrates a case where a dual-polarized feed is oriented at 45° relative to the honeycomb axis, and the same gain can be obtained. Reference can be specifically made to FIG. 18, which is a comparison diagram illustrating simulated radiation patterns for one polarization of the dual-polarized feed with and without the additional lens. The dashed line is the case of a single dipole, and the solid line is the result with the additional lens. The elevation-plane radiation pattern becomes narrower, and the gain is improved to a certain extent.

In the above cases, at the frequency of 2.2 GHz, specific gain comparisons are as follows.

| Serial number | Relationship between a polarization direction of a feed and an orientation of a metal strip | Gain (dBi) | Azimuth-plane beam width (°) | Elevation-plane beam width (°) |
|---|---|---|---|---|
| 0 | Original feed (no metal strip) | 9.63 | 55.7 | 68.8 |
| 1 | Consistency | 11.00 | 50.7 | 59.2 |
| 2 | 45° Angle | 10.38 | 52.2 | 64.9 |
| 3 | Mutually perpendicular | 10 | 54.2 | 66.7 |

As can be seen from the table, gain improvement can be achieved for three lens loading conditions 1 to 3 mentioned above. The highest is when the polarization direction and the orientation of the metal strip of the lens are in the same direction, and the maximum improvement is 1.37 dBi. A larger lens diameter and a reasonable attached metal design can achieve a gain level of 15 dBi or higher for the traditional linear array base station antenna. It can be noted that when the size of the lens unit 100 is larger, the beam gain increases greatly, and the beam width decreases greatly. For example, when the size of the lens unit 100 is 20 mm ~ 30 mm, the azimuth-plane beam width is 30°-40°, and the elevation-plane beam width is 30°-40°.

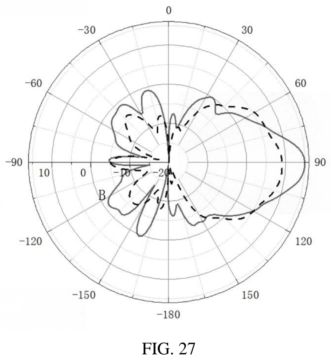

Further, a specific embodiment is provided in FIG. 26 and FIG. 27

Reference can be specifically made to FIG. 26 and FIG. 27, when the feed is still a dual-polarized dipole of 1.7-2.7 GHz and a typical gain value is required to be15 dBi, a comparison diagram of an elevation-plane radiation pattern and an azimuth-plane radiation pattern of a vertically-polarized dipole and a horizontally-polarized dipole at a frequency of 2.5 GHz is measured by using a lens unit 100 with a diameter of 30 cm. Compared with a case without loading a lens, the gain of the horizontally polarized dipole is increased by about 1 dBi, and the gain of the vertically polarized dipole is increased by about 6 dBi.

In summary, the present disclosure specifically belongs to the field of base station antennas for the 5G mobile communication network. The lens antenna 1000 technology provided in the present disclosure is also compatible with 2G, 3G, and 4G commercial mobile communication frequency ranges, and can also be compatible with the 6G high frequency range, such as a millimeter wave (mmWave) operating frequency range. Compared with the existing technology, the technology in the present disclosure has the following advantages.

First, the aramid paper-based artificial dielectric material with the honeycomb structure in the present disclosure has a stable structure, does not deform after long-term use, and prevents the metal from falling off.

Second, the value of the dielectric constant (Dk) of the aramid paper-based artificial dielectric material with the honeycomb structure in the present disclosure is achieved by means of metal screen printing, and the design is flexible.

Third, the aramid paper-based artificial dielectric material with the honeycomb structure in the present disclosure has relatively fixed metal particles, preventing contact that could affect the intermodulation indicator of the base station antenna.

Fourth, the aramid paper-based material in the present disclosure is heat-resistant and can withstand long-duration radiation from high-power base station antenna signals.

Fifth, the lens unit 100 in the present disclosure is lightweight, making it convenient for engineering construction.

Sixth, the lens unit 100 in the present disclosure is suitable for feeds in a relatively wide frequency range.

Seventh, the lens unit 100 in the present disclosure is moisture-proof and flame-retardant, making it suitable for long-term outdoor use for 10 to 30 years.

Eighth, the lens unit 100 in the present disclosure is easy to manufacture and is more suitable for mass industrial production.

Various technical features of the above-mentioned embodiments can be combined randomly, and for the sake of simplicity, not all the possible combinations of various technical features in the above-mentioned embodiments are described. However, as long as there is no contradiction between the combinations of these technical features, the combinations of these technical features can be considered as falling into the scope of the description.

Embodiments of the present disclosure are described in conjunction with the accompanying drawings above. However, the present disclosure is not limited thereto. Various alternations can be made within the knowledge of those having ordinary skills in the art without departing from the scope of the present disclosure.

**Claims**

1. An artificial dielectric material, comprising:

    a substrate, configured as a porous structure and defining a plurality of microporous chambers; and
    a conductive material, disposed on all side walls of the plurality of microporous chambers, wherein a shape of each of the plurality of microporous chambers and/or at least one of a shape, a size, or density of the conductive material are adjusted to obtain desired effective dielectric constants.

2. The artificial dielectric material of claim 1, wherein the shape of each of the plurality of microporous chambers is a hexagonal honeycomb, to make the substrate to be configured as a honeycomb structure, and the substrate is made of aramid paper.

3. The artificial dielectric material of claim 1, wherein the conductive material is configured as a plurality of metal patterns, and at least one of a shape or an orientation of each of the plurality of metal patterns or space between adjacent metal patterns is adjusted to obtain desired effective dielectric constants.

4. The artificial dielectric material of claim 3, wherein

    each of the plurality of metal patterns is a rectangular, square, circular, elliptical, or irregular two-dimensional metal sheet, or each of the plurality of metal patterns is a spherical, cuboid, cubic, ellipsoidal, cylindrical, or irregular three-dimensional metal body; and/or
    the plurality of metal patterns are uniformly distributed, or the plurality of metal patterns are not uniformly distributed; and/or
    a long side direction of each of the plurality of metal patterns is the same as a polarization direction of a polarized dipole, or a long side direction of at least one of the plurality of metal patterns is disposed at a preset angle with the polarization direction of the polarized dipole; and/or
    at least two of the plurality of metal patterns have the same shape, or all of the plurality of metal patterns have different shapes.

5. The artificial dielectric material of claim 1, wherein

the substrate is made of engineering plastics or flexible printed circuit (FPC); and/or
the shape of each of the plurality of microporous chambers is polygonal, circular, elliptical, or irregular two-dimensional, and at least two of the plurality of microporous chambers have the same shape, or all of the plurality of microporous chambers have different shapes.

6. A lens unit, comprising:
the artificial dielectric material of any one of claims 1 to 5.

7. A fabrication method for the lens unit of claim 6, comprising:

providing the substrate, and cutting the substrate to an appropriate size;
arranging the conductive material on the substrate, wherein a molding shape, a size, and distribution density of the conductive material are adjusted according to a lens design requirement during the arrangement, to achieve desired effective dielectric constants;
forming the substrate into a porous structure by means of a honeycomb preparation process, the conductive material being arranged on the side walls of each of the plurality of microporous chambers; and
processing the substrate into the lens unit.

8. The fabrication method for the lens unit of claim 7, wherein the conductive material is formed into metal patterns by metal screen printing, metal printing, or metal etching, and the metal patterns are attached to the side walls of each of the plurality of microporous chambers.

9. A lens antenna, comprising:

the lens unit of claim 6; and
a feed unit, fixed in spatial position relative to the lens unit.

10. The lens antenna of claim 9, wherein

a polarized manner of the feed unit is orthogonal dual-linear polarization; and/or
the lens unit is located directly above the feed unit or slightly offset from a directly above position, and the lens unit and the feed unit are seamlessly close to each other or are spaced apart from each other; and/or
the lens unit is cylindrical, elliptical, spherical, or ellipsoidal.

11. A lens antenna, comprising:

a lens unit, comprising a substrate and a plurality of conductive materials, wherein the substrate is of a porous structure, the substrate defines a plurality of microporous chambers, and the plurality of conductive materials are disposed on side walls of each of the plurality of microporous chambers; and
at least one feed unit, disposed facing towards or close to the lens unit, wherein a radiation surface of the at least one feed unit is disposed facing towards at least part of the plurality of conductive materials, and an angle between a polarization direction of the at least one feed unit and an extension direction of a conductive structure is less than or equal to a preset angle.

12. The lens antenna of claim 11, wherein a beam of the lens antenna changes as the angle between the extension direction of each of the plurality of conductive materials and the polarization direction of the at least one feed unit changes.

13. The lens antenna of claim 12, wherein the angle between the extension direction of each of the plurality of conductive materials and the polarization direction of the at least one feed unit is adjustable.

14. The lens antenna of claim 13, wherein

the lens unit is of a rotatable structure, and the at least one feed unit has a relatively fixed position; or

the at least one feed unit is of a rotatable structure, and the lens unit has a relatively fixed position; or both the lens unit and the at least one feed unit are of rotatable structures.

15. The lens antenna of claim 13, wherein

when the angle between the extension direction of each of the plurality of conductive materials and the polarization direction of the at least one feed unit is adjusted to a first angle range, a first beam is formed after passing through the lens unit by the at least one feed unit;

when the angle between the extension direction of each of the plurality of conductive materials and the polarization direction of the at least one feed unit is adjusted to a second angle range, a second beam is formed after passing through the lens unit by the at least one feed unit; and

when the angle between the extension direction of each of the plurality of conductive materials and the polarization direction of the at least one feed unit is adjusted to a third angle range, a third beam is formed after passing through the lens unit by the at least one feed unit; wherein

a maximum of the first angle range is less than a minimum of the second angle range, and a maximum of the second angle range is less than a minimum of the third angle range; a beam width of the first beam is smaller than a beam width of the second beam, and the beam width of the second beam is smaller than a beam width of the third beam; and a beam gain of the first beam is greater than a beam gain of the second beam, and the beam gain of the second beam is greater than a beam gain of the third beam.

16. The lens antenna of claim 13, wherein the at least one feed unit is able to rotate around the lens unit in an equatorial plane of the lens unit.

17. The lens antenna of claim 13, wherein each of the plurality of microporous chambers has a plurality of side walls, and the at least one feed unit is implemented as a plurality of feed units.

18. The lens antenna of claim 11, wherein the at least one feed unit comprises a single-polarized dipole, and the extension direction of each of the plurality of conductive materials is the same as the polarization direction of the at least one feed unit.

19. The lens antenna of claim 11, wherein the at least one feed unit comprises a dual-polarized dipole, and the extension direction of each of the plurality of conductive materials and each of two polarization-directions of the at least one feed unit are at an angle of 45°; or the extension direction of each of the plurality of conductive materials is parallel to one of the two polarization-directions of the at least one feed unit, and the extension direction of each of the plurality of conductive materials is perpendicular to the other of the two polarization-directions of the at least one feed unit.

20. The lens antenna of claim 11, wherein the at least one feed unit comprises a dual-polarized dipole, the extension direction of each of the plurality of conductive materials comprises a first direction and a second direction, the first direction is the same as one of polarization directions of the at least one feed unit, and the second direction is the same as the other of the polarization directions of the at least one feed unit.

21. The lens antenna of any one of claims 11 to 20, wherein each of the plurality of microporous chambers has a plurality of side walls, extension directions of a plurality of conductive materials on each of the plurality of side walls are the same or different, and extension directions of a plurality of conductive materials on different side walls are the same or different.

FIG. 1

FIG. 2

FIG. 3

200

FIG. 4

100    300

FIG. 5

1000

110    100

50

40    L1

300

FIG. 6

24

FIG. 7a

FIG. 7b

FIG. 8

200

300

FIG. 9a

200

300

FIG. 9b

200

300

FIG. 10a

EP 4 730 564 A1

FIG. 10b

1000

FIG. 11

27

FIG. 12a

FIG. 12b

FIG. 13a

FIG. 13b

FIG. 14a

FIG. 14b

FIG. 15

FIG. 16

FIG. 17

FIG. 18

FIG. 19a

FIG. 19b

FIG. 19c

FIG. 19d

FIG. 20a

FIG. 20b

FIG. 20c

FIG. 20d

FIG. 21a

FIG. 21b

FIG. 21c

FIG. 21d

FIG. 22a

FIG. 22b

FIG. 22c

FIG. 22d

FIG. 23a

200

300

FIG. 23b

200

300

FIG. 23c

200

300

FIG. 23d

FIG. 24a

FIG. 24b

FIG. 24c

FIG. 24d

FIG. 24e

FIG. 25a

FIG. 25b

FIG. 26

FIG. 27

## INTERNATIONAL SEARCH REPORT

| International application No. |
|---|
| **PCT/CN2024/098429** |

### A. CLASSIFICATION OF SUBJECT MATTER

H01Q 15/08(2006.01)i

According to International Patent Classification (IPC) or to both national classification and IPC

### B. FIELDS SEARCHED

Minimum documentation searched (classification system followed by classification symbols)

IPC: H01Q

Documentation searched other than minimum documentation to the extent that such documents are included in the fields searched

Electronic data base consulted during the international search (name of data base and, where practicable, search terms used)

CNTXT, WPABSC, ENTXT, CNKI, IEEE: 介质, 基材, 基板, 透镜, 天线, 馈源, 导电, 导体, 金属, 贴片, 侧壁, 内壁, 内表面, 孔, 介电常数, medium, base, lens, antenna, feed, conduct+, metal, patch, side wall, inwall, micropore chamber, hole, dielectric constant

### C. DOCUMENTS CONSIDERED TO BE RELEVANT

| Category* | Citation of document, with indication, where appropriate, of the relevant passages | Relevant to claim No. |
|---|---|---|
| PX | CN 116435793 A (SOUTH CHINA UNIVERSITY OF TECHNOLOGY et al.) 14 July 2023 (2023-07-14) <br> claims 1-10, description, paragraphs [0031]-[0076], and figures 1-18 | 1-21 |
| Y | CN 102790278 A (KUANG-CHI INSTITUTE OF ADVANCED TECHNOLOGY et al.) 21 November 2012 (2012-11-21) <br> description, paragraphs [0036]-[0056], and figures 1-7 | 1-21 |
| Y | CN 114946085 A (VASANT PTY LTD) 26 August 2022 (2022-08-26) <br> description, paragraphs [0079]-[0100], and figures 1-14 | 1-21 |
| A | CN 113875090 A (GUANGZHOU SINAN TECHNOLOGY CO., LTD.) 31 December 2021 (2021-12-31) <br> entire document | 1-21 |
| A | WO 2022265524 A1 (VASANT LIMITED) 22 December 2022 (2022-12-22) <br> entire document | 1-21 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **15 August 2024** | **21 August 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/098429**

| Patent document cited in search report | | | Publication date (day/month/year) | Patent family member(s) | | | Publication date (day/month/year) |
|---|---|---|---|---|---|---|---|
| CN | 116435793 | A | 14 July 2023 | None | | | |
| CN | 102790278 | A | 21 November 2012 | None | | | |
| CN | 114946085 | A | 26 August 2022 | EP | 4091214 | A1 | 23 November 2022 |
| | | | | WO | 2021145780 | A1 | 22 July 2021 |
| | | | | US | 2022209418 | A1 | 30 June 2022 |
| CN | 113875090 | A | 31 December 2021 | WO | 2020218927 | A1 | 29 October 2020 |
| | | | | EP | 3959776 | A1 | 02 March 2022 |
| | | | | US | 2021091478 | A1 | 25 March 2021 |
| WO | 2022265524 | A1 | 22 December 2022 | US | 2023395986 | A1 | 07 December 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310709691

- CN 202410667877X